# EUROPEAN PATENT APPLICATION

(11) **EP 4 592 752 A2**
(43) Date of publication of application: **30.07.2025**
(21) Application number: 25152757.8
(22) Date of filing: 20.01.2025
(51) Int. Cl.: G03F 7/075, G03F 7/09

(54) **COMPOSITION FOR FORMING METAL-CONTAINING FILM AND PATTERNING PROCESS**

(30) Priority: 23.01.2024 JP 2024008325
(71) Applicant: SHIN-ETSU CHEMICAL CO., LTD., Tokyo 1000005 (JP)
(72) Inventor: Kobayashi, Naoki, Niigata (JP); Takizawa, Kanata, Niigata (JP); Ishiwata, Kenta, Niigata (JP)
(74) Representative: Sonnenhauser, Thomas Martin

(57) **Abstract**

The present invention aims to provide: a composition for forming a resist underlayer film to be used for forming a resist underlayer film capable of contributing to sensitivity enhancement while keeping LWR of an upper layer resist; and a patterning process using this composition. Provided is a composition for forming a metal-containing film contains (A) a silicon-containing polymer containing polysiloxane, polycarbosilane, or polysilane, (B) a metal source, and (C) an organic solvent, wherein the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

## Description

### TECHNICAL FIELD

The present invention relates to: a composition for forming a metal-containing film usable for fine patterning by a multilayer resist method during semiconductor apparatus manufacturing processes; and a patterning process using the composition.

### BACKGROUND ART

As higher integration and speed are achieved in LSI, miniaturization of a pattern rule progresses rapidly. In particular, logic devices used in smartphones, etc. lead the miniaturization, and 10-nm node logic devices are produced in large quantities using a multiple exposure (multi-patterning lithography) process by ArF lithography.

Regarding lithography of next 7-nm node and 5-nm node, increased cost due to multiple exposure and a problem of overlay accuracy of multiple exposure become apparent, and the advent of EUV lithography enabling to reduce the number of exposure is desired.

Since extreme ultraviolet (EUV) has a short wavelength of 13.5 nm, that is equal to or shorter than 1/10 of that of an ArF excimer laser having a wavelength of 193 nm, EUV lithography achieves a high light contrast and is expected to have high resolution. Because of the short wavelength and high energy density of EUV, an acid generator is sensitive to a small amount of photons. It is believed that the number of photons in EUV exposure is 1/14 of that of ArF exposure. In the EUV exposure, a phenomenon in which variation in photons causes degraded line width roughness (LWR) and critical dimension uniformity (CDU) of a hole is considered as a problem (Non Patent Document 1). Furthermore, possible influences of localization or agglomeration of a base polymer or an acid generator as well as acid diffusion caused by an acid generator are also pointed out.

To address these, for example, it is possible to reduce LWR by decreasing temperature during post exposure bake (PEB), but sensitivity of an EUV resist is reduced. Furthermore, LWR is also reduced by increasing an amount of a quencher to be added, but this method also leads to the reduced sensitivity. For the practical application of an EUV resist, it is necessary to overcome the trade-off relationship between sensitivity and LWR.

In order to put EUV lithography into practical application as a mass-production process of semiconductor apparatuses, there are many problems to be solved. Among the problems, the property particularly required to be improved is to enhance sensitivity while keeping LWR. Patent Document 1 has disclosed a method for forming a lower layer film including a sensitizer, the sensitizer absorbing EUV light and generating a secondary electron. Patent Document 2 has disclosed that a thermosetting silicon-containing material that contains iodine is capable of contributing to sensitivity enhancement of an upper layer resist while keeping LWR thereof. However, for the above material design, an incorporation rate of an element with high optical absorption is limited, and it is considered that material design contributing more to the sensitivity enhancement of a resist is necessary.

To address the above problem, a possible method is by means of introduction of a resist underlayer film containing a metal element with a high absorption coefficient at EUV light. Patent Document 3 has disclosed a composition of spin-on materials containing metal oxide nanoparticles and an organic polymer. Although the evaluation of pattern formation in an EUV resist has not been mentioned, it is assumed that a resist underlayer film containing many metal elements with high optical absorption can be formed. However, since a film formed using metal nanoparticles has crystallinity, there is a risk of degraded line width roughness (LWR) of a pattern during etching of a substrate to be processed if nanoparticles are used in the resist underlayer film material.

Patent Document 4 has proposed a resist composition including a polymer containing repeating units having an acid labile group-substituted carboxyl group or a phenolic hydroxy group, an acid generator, and various metal salts of carboxylic acid or various metal complexes of β-diketone. In this case, acid generated by the acid generator undergoes ion exchange with the various metal salts of carboxylic acid or various metal complexes of β-diketone, and as a result, the acid is trapped. The metal salt of carboxylic acid or the metal complex of β-diketone functions as a quencher for the acid catalyst, and is effective for controlling acid diffusion but not actively enhancing sensitivity. A breakthrough is desired to increase sensitivity while controlling acid diffusion.

### CITATION LIST

### PATENT LITERATURE

Patent Document 1: JP 5705103 B
Patent Document 2: JP 2020-084175 A
Patent Document 3: JP 7008075 B
Patent Document 4: JP 5601286 B

### NON PATENT LITERATURE

Non Patent Document 1: SPIE, Vol. 3331, p. 531 (1998)

### SUMMARY OF INVENTION

### TECHNICAL PROBLEM

In view of the circumstances, the present invention aims to provide: a composition for forming a metal-containing film to be used for forming a metal-containing film capable of contributing to sensitivity enhancement while keeping LWR of an upper layer resist; and a patterning process using this composition.

### SOLUTION TO PROBLEM

To achieve the above object, the present invention provides a composition for forming a metal-containing film, containing (A) a silicon-containing polymer containing polysiloxane, polycarbosilane, or polysilane, (B) a metal source, and (C) an organic solvent,
wherein the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

Such composition for forming a metal-containing film enables to form a resist underlayer film or middle layer film capable of contributing to sensitivity enhancement while keeping LWR of an upper layer resist.

Additionally, the polysiloxane in the component (A) preferably contains any one or more of a repeating unit represented by the following general formula (Sx-1), a repeating unit represented by the following general formula (Sx-2), and a partial structure represented by the following general formula (Sx-3), 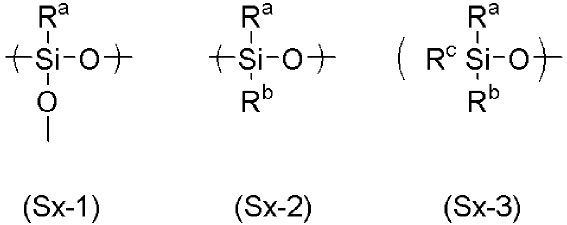 wherein R^{a}, R^{b}, and R^{c} are identical to or different from each other, and each represents a monovalent organic group having 1 to 30 carbon atoms.

By using such composition for forming a metal-containing film, it is possible to enhance adhesiveness to a resist pattern and prevent collapse of a fine pattern.

In this case, at least one of the R^{a} to R^{c} in the formulae (Sx-1) to (Sx-3) preferably represents an organic group having one or more carbon-oxygen single bonds or carbon-oxygen double bonds.

By using such composition for forming a metal-containing film, it is possible to enhance adhesiveness to a resist pattern and prevent collapse of a fine pattern.

Additionally, the polycarbosilane in the component (A) preferably contains a unit structure represented by the following general formula (Sy-1), 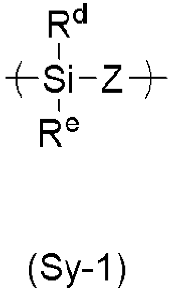 wherein R^{d} and R^{e} each independently represents a hydrogen atom, a hydroxy group, a halogen atom, or a monovalent organic group having 1 to 30 carbon atoms; and Z represents a substituted or unsubstituted divalent hydrocarbon group having 1 to 20 carbon atoms.

By using such composition for forming a metal-containing film, it is possible to enhance adhesiveness to a resist pattern and prevent collapse of a fine pattern.

Additionally, the polysilane in the component (A) preferably contains a repeating unit represented by the following general formula (Sz-1),

(R⁹R¹⁰R¹¹Si)ₐ₂(R¹²R¹³Si)ₐ₃(R¹⁴Si)ₐ₄(Si)ₐ₅ (Sz-1)

wherein each of R⁹, R¹⁰, R¹¹, R¹², R¹³, and R¹⁴ represents a methyl group, a phenyl group, or a hydroxyl group; and "a2", "a3", "a4", and "a5" each represents a mole fraction, satisfying a2+a3+a4+a5=1, 0≤a2≤1, 0≤a3≤1, 0≤a4≤1, and 0≤a5≤1.

By using such composition for forming a metal-containing film, it is possible to enhance adhesiveness to a resist pattern and prevent collapse of a fine pattern.

Additionally, the metal source (B) is preferably a salt of the metal with a monovalent to tetravalent carboxylic acid having 1 to 30 carbon atoms.

Such composition for forming a metal-containing film enables to form a resist underlayer film or middle layer film capable of contributing to sensitivity enhancement while keeping LWR of an upper layer resist. Furthermore, it is possible to form a resist underlayer film exhibiting excellent dry etching resistance upon transferring of a pattern to the resist underlayer film. Thus, it is possible to transfer an upper layer resist pattern to a substrate to be processed with high precision.

Additionally, the metal source (B) preferably has a structure represented by the following formula (B-1), 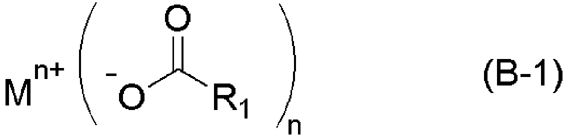 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.

Such composition for forming a metal-containing film enables to form a resist underlayer film or middle layer film capable of contributing to sensitivity enhancement while keeping LWR of an upper layer resist. Furthermore, it is possible to form a resist underlayer film exhibiting excellent dry etching resistance upon transferring of a pattern to the resist underlayer film. Thus, it is possible to transfer an upper layer resist pattern to a substrate to be processed with high precision.

In this case, R₁ in the formula (B-1) preferably represents a saturated or unsaturated hydrocarbon group having 1 to 10 carbon atoms.

When such metal source (B) is used in the composition for forming a metal-containing film, favorable solubility in an organic solvent can be achieved, and a resist underlayer film or middle layer film can be formed with excellent film formability and fewer defects.

Further in this case, R₁ in the formula (B-1) preferably represents a branched alkyl group having 3 to 10 carbon atoms.

When such metal source (B) is used in the composition for forming a metal-containing film, favorable solubility in an organic solvent can be achieved, and a resist underlayer film or middle layer film can be formed with excellent film formability and fewer defects.

Additionally, the metal of the metal source (B) is preferably Sn.

Such composition for forming a metal-containing film enables to form a resist underlayer film or middle layer film capable of contributing to sensitivity enhancement while keeping LWR of an upper layer resist.

Additionally, the composition preferably further contains one or more of (D) a crosslinking agent, (E) an acid generator, (F) a surfactant, and (G) a colorant.

To the composition of the present invention, these additives can be added as necessary.

Additionally, the organic solvent (C) is preferably a mixture of one or more kinds of organic solvents having a boiling point of less than 180°C and one or more kinds of organic solvents having a boiling point of 180°C or higher ((C') a high-boiling-point solvent).

Since addition of the high-boiling-point solvent imparts flowability to the above composition for forming a metal-containing film, it is possible to prevent application defects due to dryness of the composition for forming a metal-containing film.

The present invention also provides a patterning process for forming a pattern in a substrate to be processed, including steps of:
(I-1) applying the above composition for forming a metal-containing film on the substrate to be processed and thereafter performing heat treatment to form a metal-containing film;
(I-2) forming a resist upper layer film on the metal-containing film using a photoresist material;
(I-3) forming a pattern in the resist upper layer film by developing the resist upper layer film using a developer after pattern exposure;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process with the above two-layer resist process is capable of forming a fine pattern in a workpiece (substrate to be processed).

The present invention also provides a patterning process for forming a pattern in a substrate to be processed, including steps of:
(II-1) forming an organic resist underlayer film on the substrate to be processed;
(II-2) applying the above composition for forming a metal-containing film on the organic resist underlayer film and thereafter performing heat treatment to form a metal-containing film;
(II-3) forming a resist upper layer film on the metal-containing film using a photoresist material;
(II-4) forming a pattern in the resist upper layer film by developing the resist upper layer film using a developer after pattern exposure;
(II-5) transferring the pattern to the metal-containing film by dry etching while using the resist upper layer film having the formed pattern as a mask;
(II-6) transferring the pattern to the organic resist underlayer film by dry etching while using the metal-containing film having the transferred pattern as a mask; and
(II-7) processing the substrate to be processed while using the organic resist underlayer film having the formed pattern as a mask to form the pattern in the substrate to be processed.

The patterning process with the above three-layer resist process is capable of forming a fine pattern in a workpiece with high precision.

Additionally, the pattern exposure is preferably performed using EUV light in the step (I-3).

Additionally, the pattern exposure is preferably performed using EUV light in the step (II-4).

Since the composition for forming a metal-containing film of the present invention contains a metal atom with high optical absorption, it enables to form a resist underlayer film or middle layer film capable of contributing to sensitivity enhancement while keeping LWR of an upper layer resist in EUV lithography.

### ADVANTAGEOUS EFFECTS OF INVENTION

The composition for forming a metal-containing film of the present invention can provide a resist underlayer film with a high metal content, because the metal salt structure is decomposed by heat treatment to cause metal ion desorption, thereby forming a metal oxide. Since the film contains a large number of metal atoms with high optical absorption, it has a feature that a sensitizing effect can be expected due to secondary electrons generated from these metal atoms during exposure in EUV lithography. Furthermore, since the above metal atom has a large atomic weight, it has features of a high suppression effect on acid diffusion from an upper layer resist into the resist underlayer film, and ability to increase sensitivity while maintaining an inherent LWR performance of a resist upper layer film. Additionally, the composition for forming a metal-containing film contains polysiloxane or polysilane having excellent adhesiveness to a resist upper layer film pattern, and thus it is effective in controlling collapse of a fine pattern and can provide a very effective patterning process for lithography using EUV light.

### BRIEF DESCRIPTION OF DRAWINGS

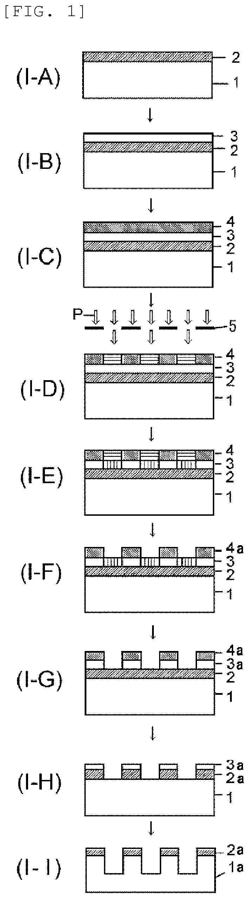

FIG. 1 is a diagram illustrating a patterning process according to an embodiment of the present invention (three-layer resist process).

### DESCRIPTION OF EMBODIMENTS

As described above, it has been demanded to develop: a composition for forming a metal-containing film, capable of contributing to sensitivity enhancement while keeping LWR of an upper layer resist in a fine patterning process using a multilayer resist method; and a patterning process using the composition.

The present inventors focused on a metal material with high absorption of EUV light, and made an intensive investigation. A metal oxide film formed by spin coating is one option, but poor adhesiveness thereof to an upper layer resist film makes it difficult to control collapse of a fine pattern. The present inventors have found that a composition for forming a metal-containing film containing a silicon-containing polymer and a predetermined metal compound enables to form a resist underlayer film or middle layer film excellent in adhesiveness to an upper layer resist film, where a number of metal elements with high absorption of EUV light are contained in the film, and completed the present invention.

Thus, the present invention is a composition for forming a metal-containing film, containing (A) a silicon-containing polymer containing polysiloxane, polycarbosilane, or polysilane, (B) a metal source, and (C) an organic solvent, wherein the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

Hereinafter, the present invention will be described in detail. However, the present invention is not limited thereto.

### <(A) Silicon-Containing Polymer>

The silicon-containing polymer (A) contained in the composition for forming a metal-containing film of the present invention contains polysiloxane (Sx), polycarbosilane (Sy), or polysilane (Sz).

By containing such resin, the composition for forming a metal-containing film enables to form a resist underlayer film or middle layer film having excellent adhesiveness to a resist upper layer film pattern.

### <Polysiloxane (Sx)>

The polysiloxane (Sx) preferably contains any one or more of a repeating unit represented by the following general formula (Sx-1), a repeating unit represented by the following general formula (Sx-2), and a partial structure represented by the following general formula (Sx-3), 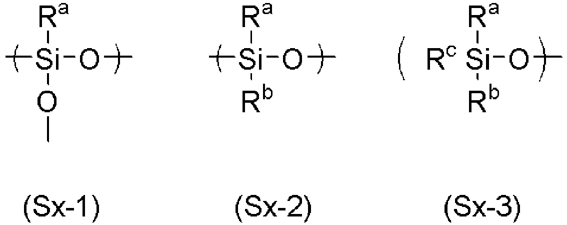 wherein R^{a}, R^{b}, and R^{c} may be identical to or different from each other, and each represents a monovalent organic group having 1 to 30 carbon atoms.

The above polysiloxane (hereinafter also referred to as thermally crosslinkable polysiloxane) (Sx) can be produced by hydrolysis condensation of the following hydrolyzable monomer (Sm).

Specific examples of the hydrolyzable monomer (Sm) include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, phenyltrimethoxysilane, phenyltriethoxysilane, phenyltripropoxysilane, phenyltriisopropoxysilane, benzyltrimethoxysilane, benzyltriethoxysilane, benzyltripropoxysilane, benzyltriisopropoxysilane, anisyltrimethoxysilane, anisyltriethoxysilane, anisyltripropoxysilane, anisyltriisopropoxysilane, tolyltrimethoxysilane, tolyltriethoxysilane, tolyltripropoxysilane, tolyltriisopropoxysilane, phenethyltrimethoxysilane, phenethyltriethoxysilane, phenethyltripropoxysilane, phenethyltriisopropoxysilane, naphthyltrimethoxysilane, naphthyltriethoxysilane, naphthyltripropoxysilane, naphthyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl)dimethoxysilane, bis(bicycloheptyl)diethoxysilane, bis(bicycloheptyl)dipropoxysilane, bis(bicycloheptyl)diisopropoxysilane, diadamantyldimethoxysilane, diadamantyldiethoxysilane, diadamantyldipropoxysilane, diadamantyldiisopropoxysilane, diphenyldimethoxysilane, diphenyldiethoxysilane, methylphenyldimethoxysilane, methylphenyldiethoxysilane, diphenyldipropoxysilane, diphenyldiisopropoxysilane, trimethylmethoxysilane, trimethylethoxysilane, dimethylethylmethoxysilane, dimethylethylethoxysilane, dimethylphenylmethoxysilane, dimethylphenylethoxysilane, dimethylbenzylmethoxysilane, dimethylbenzylethoxysilane, dimethylphenethylmethoxysilane, dimethylphenethylethoxysilane, and the like.

Preferred examples of the above hydrolyzable monomer (Sm) include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, phenethyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, methylphenyldimethoxysilane, methylphenyldiethoxysilane, trimethylmethoxysilane, dimethylethylmethoxysilane, dimethylphenylmethoxysilane, dimethylbenzylmethoxysilane, dimethylphenethylmethoxysilane, and the like.

Other examples of the organic groups represented by R^{a}, R^{b}, and R^{c}, which correspond to the compounds exemplified above for the hydrolyzable monomer (Sm), include organic groups having one or more carbon-oxygen single bonds or carbon-oxygen double bonds. Specifically, the organic group contains one or more groups selected from a group consisting of an ether bond, an ester bond, an alkoxy group, a hydroxy group, and the like. Examples thereof include the one represented by the following general formula (Sm-R).

(P-Q₁-(S₁)ᵥ₁-Q₂-)ᵤ-(T)ᵥ₂-Q₃-(S₂)ᵥ₃-Q₄- (Sm-R)

(In the general formula (Sm-R), P represents a hydrogen atom, a cyclic ether group, a hydroxyl group, an alkoxy group having 1 to 4 carbon atoms, an alkylcarbonyloxy group having 1 to 6 carbon atoms, or an alkylcarbonyl group having 1 to 6 carbon atoms; each of Q₁, Q₂, Q₃, and Q₄ independently represents -C_{q}H(_{2q-p})Pₚ- (wherein P is as defined above, "p" represents an integer of 0 to 3, and "q" represents an integer of 0 to 10, provided that q=0 means a single bond); "u" represents an integer of 0 to 3; each of S₁ and S₂ independently represents -O-, -CO-, -OCO-, -COO-, or -OCOO-; each of "v1", "v2", and "v3" independently represents 0 or 1; and T represents a divalent atom other than carbon, or a divalent group of an alicyclic, aromatic, or heterocyclic ring. As the T, examples of the alicyclic, aromatic, or heterocyclic ring optionally containing a heteroatom such as an oxygen atom are shown below. In the T, positions bonded to Q₂ and Q₃ are not particularly limited, and can be selected as appropriate in consideration of reactivity dependent on steric factors, availability of commercial reagents used in the reaction, etc.)

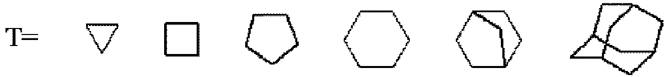

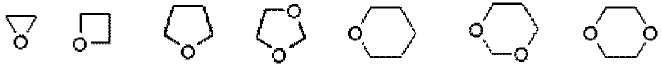

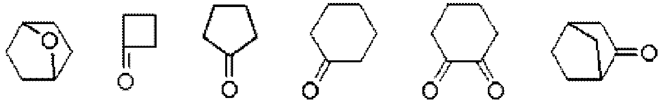

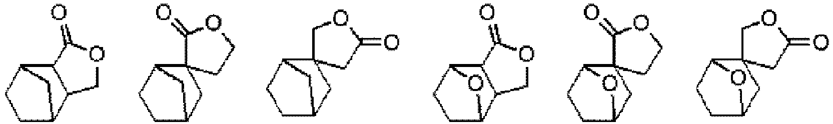

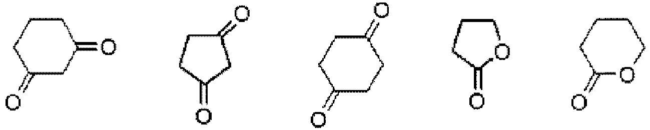

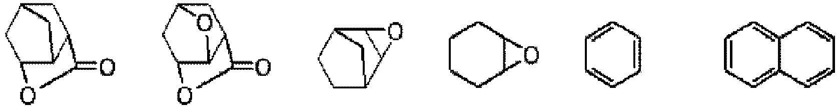

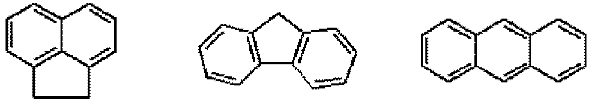

Preferred examples of the organic group having one or more carbon-oxygen single bonds or carbon-oxygen double bonds in the general formula (Sm-R) include the following. Note that in the following formulae, (Si) represents a bonding site to Si.

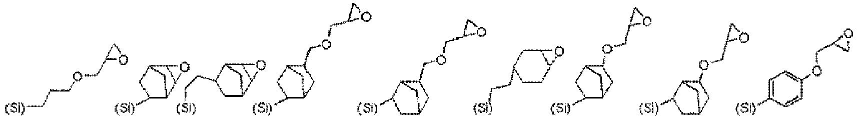

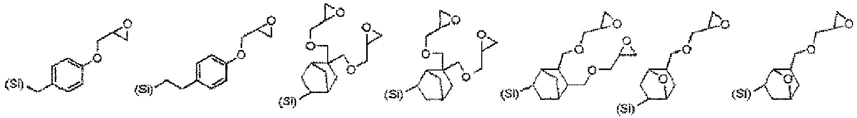

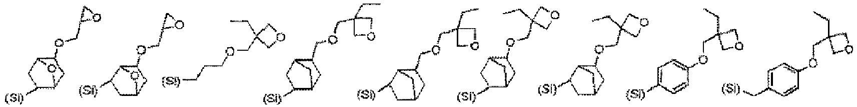

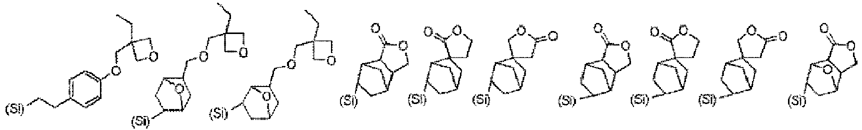

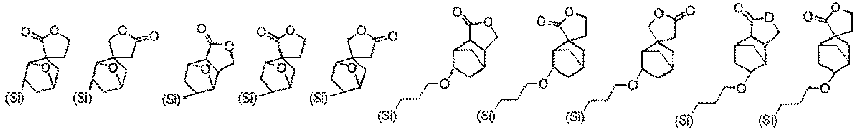

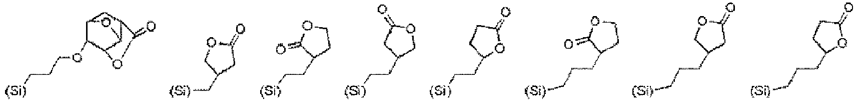

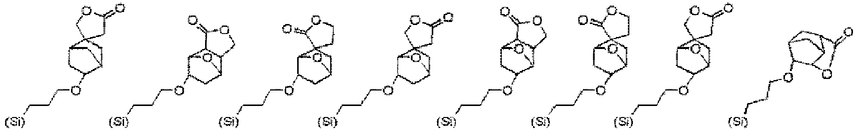

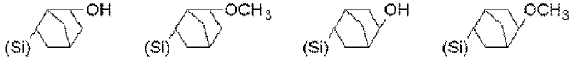

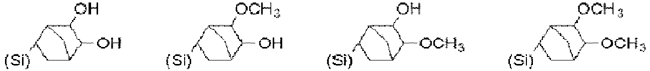

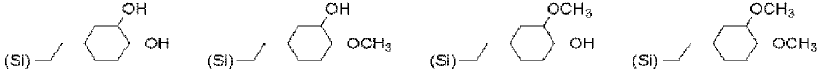

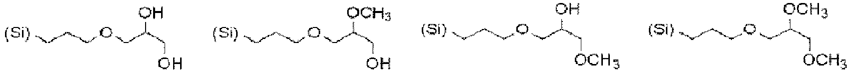

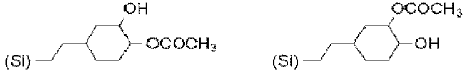

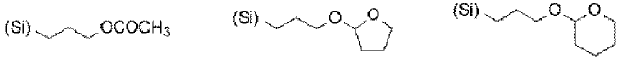

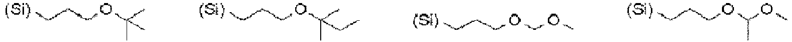

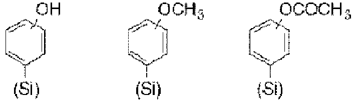

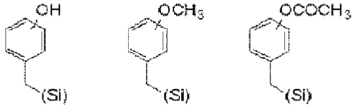

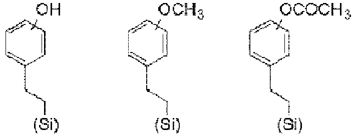

When at least one of R^{a} to R^{c} in the formulae (Sx-1) to (Sx-3) represents an organic group having one or more carbon-oxygen single bonds or carbon-oxygen double bonds, adhesiveness to a resist upper layer film pattern can further be enhanced.

Additionally, as the exemplary organic groups of R^{a}, R^{b}, and R^{c}, an organic group containing a silicon-silicon bond can also be used. Specific examples thereof include the following.

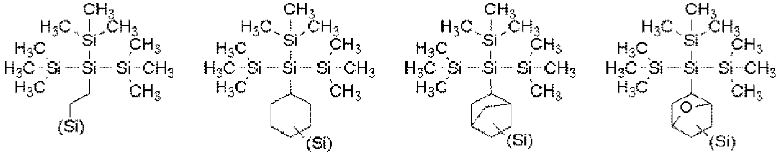

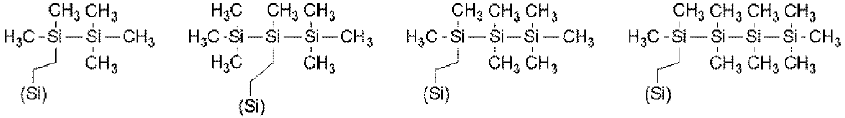

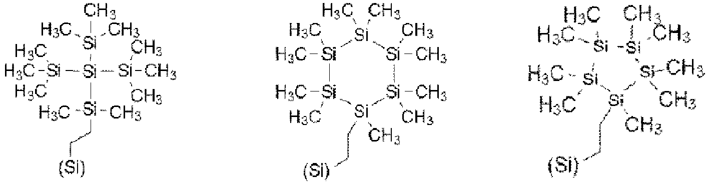

Additionally, as the exemplary organic groups of R^{a}, R^{b}, and R^{c}, an organic group containing a protective group which is decomposed with acid can also be used. Specific examples thereof include organic groups described in paragraphs [0043] to [0048] of JP 2013-167669 A, and organic groups obtained from silicon compounds described in paragraph [0056] of JP 2013-224279 A.

Further, as the exemplary organic groups of R^{a}, R^{b}, and R^{c}, an organic group having a fluorine atom can also be used. Specific examples thereof include organic groups obtained from silicon compounds described in paragraphs [0059] to [0065] of JP 2012-53253 A.

To enhance sensitivity of a resist upper layer film in EUV lithography, the organic group having a fluorine atom is preferably contained as the organic groups of R^{a}, R^{b}, and R^{c}.

Furthermore, as the exemplary organic groups of R^{a}, R^{b}, and R^{c}, an organic group having an iodine atom can also be used. Specific examples thereof include organic groups obtained from silicon compounds described in paragraphs [0043] to [0047] of JP 2023-116531 A.

To enhance sensitivity of a resist upper layer film in EUV lithography, the organic group having an iodine atom is preferably contained as the organic groups of R^{a}, R^{b}, and R^{c}.

In the hydrolyzable monomer (Sm), one, two, or three hydrolyzable group(s) such as chlorine, bromine, iodine, an acetoxy group, a methoxy group, an ethoxy group, a propoxy group, and a butoxy group are bonded onto the silicon represented by (Si) in the above partial structure.

### Method for Synthesizing Polysiloxane (Sx)

### (Synthesis Method 1: Acid Catalyst)

The polysiloxane (thermally crosslinkable polysiloxane) (Sx) used in the present invention can be produced by hydrolysis condensation of one kind of the hydrolyzable monomer (Sm) or a mixture of two or more kinds thereof in the presence of an acid catalyst.

Examples of the acid catalyst used in this event include: organic acids such as formic acid, acetic acid, oxalic acid, maleic acid, methanesulfonic acid, benzenesulfonic acid, and toluenesulfonic acid; and inorganic acids such as hydrofluoric acid, hydrochloric acid, hydrobromic acid, sulfuric acid, nitric acid, perchloric acid, and phosphoric acid. The catalyst is used in an amount of 1×10⁻⁶ to 10 mol, preferably 1×10⁻⁵ to 5 mol, and more preferably 1×10⁻⁴ to 1 mol per mol of the monomer.

When the thermally crosslinkable polysiloxane (Sx) is obtained from such monomer by the hydrolysis condensation, water is added in an amount of preferably 0.01 to 100 mol, more preferably 0.05 to 50 mol, and further preferably 0.1 to 30 mol per mol of the hydrolyzable substituent bonded to the monomer. When the amount is 100 mol or less, an apparatus used for the reaction can be made small and economical.

As the operation method, the monomer is added to a catalyst aqueous solution to start the hydrolysis condensation reaction. In this event, an organic solvent may be added to the catalyst aqueous solution, or the monomer may be diluted with the organic solvent, or both of these operations may be performed. A reaction temperature is 0 to 100°C, preferably 5 to 80°C. As a preferable method, the temperature is maintained at 5 to 80°C when the monomer is being added dropwise, and then the resultant is aged at 20 to 80°C.

The organic solvent which can be added to the catalyst aqueous solution or with which the monomer can be diluted is preferably methanol, ethanol, 1-propanol, 2-propanol, 1-butanol, 2-butanol, 2-methyl-1-propanol, acetone, acetonitrile, tetrahydrofuran, toluene, hexane, ethyl acetate, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, t-butyl propionate, propylene glycol mono-t-butyl ether acetate, γ-butyrolactone, mixtures thereof, or the like.

Among these solvents, water-soluble solvents are preferable. Examples thereof include: alcohols such as methanol, ethanol, 1-propanol, and 2-propanol; polyhydric alcohols such as ethylene glycol and propylene glycol; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone, acetonitrile, tetrahydrofuran, and the like. Among these, particularly preferred is the one having a boiling point of 100°C or less.

Note that the organic solvent is preferably used in an amount of 0 to 1,000 ml, particularly in an amount of 0 to 500 ml, per mol of the monomer. When the organic solvent is used in a small amount, a reaction vessel can be made small and economical.

Then, if necessary, neutralization reaction of the catalyst is carried out to obtain a reaction mixture aqueous solution. In this case, the amount of an alkaline substance usable for the neutralization is preferably 0.1 to 2 equivalents relative to the acid used as the catalyst. This alkaline substance may be any substance as long as it exhibits alkalinity in water.

Subsequently, by-products such as alcohol generated by the hydrolysis condensation reaction are preferably removed under reduced pressure or by other techniques from the reaction mixture. In this event, the reaction mixture is heated at a temperature of preferably 0 to 100°C, more preferably 10 to 90°C, and further preferably 15 to 80°C, depending on the kinds of the added organic solvent, the alcohol generated by the reaction, etc. Additionally, a degree of pressure reduction in this event is preferably atmospheric pressure or less, more preferably 80 kPa or less in absolute pressure, and further preferably 50 kPa or less in absolute pressure, that varies depending on the kinds of the organic solvent, alcohol, etc. to be removed, as well as an exhaust apparatus, a condensation apparatus, and the heating temperature. Although it is difficult to accurately know the amount of the alcohol to be removed on this occasion, it is preferable to remove about 80% by mass or more of the generated alcohol, etc.

Next, the acid catalyst used in the hydrolysis condensation may be removed from the reaction mixture. As a method for removing the acid catalyst, the thermally crosslinkable polysiloxane solution is mixed with water, and the thermally crosslinkable polysiloxane is extracted with an organic solvent. The organic solvent used in this event is preferably the one capable of dissolving the thermally crosslinkable polysiloxane and causes two-layer separation when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, mixtures thereof, and the like.

Further, it is also possible to use a mixture of a water-soluble organic solvent and a slightly-water-soluble organic solvent. Preferred examples thereof include mixtures of methanol-ethyl acetate, ethanol-ethyl acetate, 1-propanol-ethyl acetate, 2-propanol-ethyl acetate, butanediol monomethyl ether-ethyl acetate, propylene glycol monomethyl ether-ethyl acetate, ethylene glycol monomethyl ether-ethyl acetate, butanediol monoethyl ether-ethyl acetate, propylene glycol monoethyl ether-ethyl acetate, ethylene glycol monoethyl ether-ethyl acetate, butanediol monopropyl ether-ethyl acetate, propylene glycol monopropyl ether-ethyl acetate, ethylene glycol monopropyl ether-ethyl acetate, methanol-methyl isobutyl ketone, ethanol-methyl isobutyl ketone, 1-propanol-methyl isobutyl ketone, 2-propanol-methyl isobutyl ketone, propylene glycol monomethyl ether-methyl isobutyl ketone, ethylene glycol monomethyl ether-methyl isobutyl ketone, propylene glycol monoethyl ether-methyl isobutyl ketone, ethylene glycol monoethyl ether-methyl isobutyl ketone, propylene glycol monopropyl ether-methyl isobutyl ketone, ethylene glycol monopropyl ether-methyl isobutyl ketone, methanol-cyclopentyl methyl ether, ethanol-cyclopentyl methyl ether, 1-propanol-cyclopentyl methyl ether, 2-propanol-cyclopentyl methyl ether, propylene glycol monomethyl ether-cyclopentyl methyl ether, ethylene glycol monomethyl ether-cyclopentyl methyl ether, propylene glycol monoethyl ether-cyclopentyl methyl ether, ethylene glycol monoethyl ether-cyclopentyl methyl ether, propylene glycol monopropyl ether-cyclopentyl methyl ether, ethylene glycol monopropyl ether-cyclopentyl methyl ether, methanol-propylene glycol methyl ether acetate, ethanol-propylene glycol methyl ether acetate, 1-propanol-propylene glycol methyl ether acetate, 2-propanol-propylene glycol methyl ether acetate, propylene glycol monomethyl ether-propylene glycol methyl ether acetate, ethylene glycol monomethyl ether-propylene glycol methyl ether acetate, propylene glycol monoethyl ether-propylene glycol methyl ether acetate, ethylene glycol monoethyl ether-propylene glycol methyl ether acetate, propylene glycol monopropyl ether-propylene glycol methyl ether acetate, ethylene glycol monopropyl ether-propylene glycol methyl ether acetate, and the like. The combination is not limited thereto.

Note that a mixing ratio of the water-soluble organic solvent and the slightly-water-soluble organic solvent is selected as appropriate, and the amount of the water-soluble organic solvent is 0.1 to 1,000 parts by mass, preferably 1 to 500 parts by mass, and further preferably 2 to 100 parts by mass relative to 100 parts by mass of the slightly-water-soluble organic solvent.

Subsequently, washing with neutral water may be performed. As this water, what is commonly called deionized water or ultrapure water may be used. The amount of the water is preferably 0.01 to 100 L, more preferably 0.05 to 50 L, and further preferably 0.1 to 5 L relative to 1 L of the thermally crosslinkable polysiloxane solution. This washing method may be performed by putting both into the same container, stirring and thereafter leaving them to stand to separate an aqueous layer. The washing may be performed one or more times. Since washing ten times or more does not always exert its full washing effect, the washing is preferably performed one to five times or so.

Other methods for removing the acid catalyst include a method using an ion-exchange resin, and a method in which the acid catalyst is removed after neutralization with an epoxy compound such as ethylene oxide and propylene oxide. These methods can be selected as appropriate according to the acid catalyst used in the reaction.

In this water-washing operation, a part of the thermally crosslinkable polysiloxane escapes into the aqueous layer, so that substantially the same effect as a fractionation operation may be obtained. Therefore, the number of times of the water-washing and the amount of the washing water may be selected as appropriate in view of the catalyst removal effect and the fractionation effect.

To a solution of either the thermally crosslinkable polysiloxane with the acid catalyst still remaining or the thermally crosslinkable polysiloxane with the acid catalyst removed, a final solvent is added to perform solvent exchange under reduced pressure, thereby obtaining the desired thermally crosslinkable polysiloxane solution. The temperature during this solvent exchange is preferably 0 to 100°C, more preferably 10 to 90°C, and further preferably 15 to 80°C, depending on the kinds of the reaction solvent and the extraction solvent to be removed. Additionally, the degree of pressure reduction in this event is preferably atmospheric pressure or less, more preferably 80 kPa or less in absolute pressure, and further preferably 50 kPa or less in absolute pressure, that varies depending on the kind of the extraction solvent to be removed, as well as the exhaust apparatus, the condensation apparatus, and the heating temperature.

In this event, the thermally crosslinkable polysiloxane may become unstable due to changing of the solvent. This is caused by compatibility between the final solvent and the thermally crosslinkable polysiloxane. To prevent this phenomenon, monohydric, dihydric, or polyhydric alcohol containing a cyclic ether as a substituent described in paragraphs [0181] to [0182] of JP 2009-126940 A may be added as a stabilizer. The addition amount is 0 to 25 parts by mass, preferably 0 to 15 parts by mass, and more preferably 0 to 5 parts by mass relative to 100 parts by mass of the thermally crosslinkable polysiloxane in the solution before the solvent exchange. The amount (if added) is preferably 0.5 parts by mass or more. If necessary, the monohydric, dihydric, or polyhydric alcohol containing a cyclic ether as a substituent may be added to the solution before the solvent exchange to perform the solvent exchange operation.

If the thermally crosslinkable polysiloxane is concentrated to a certain concentration level or higher, the condensation reaction further progresses, causing a risk of changing it into an insoluble state in an organic solvent. Thus, it is preferably maintained in a solution state with a proper concentration. Furthermore, since the too low concentration leads to the excessive amount of the solvent, the solution state with a proper concentration is economical and preferable. The concentration in this case is preferably 0.1 to 20% by mass.

The final solvent to be added to the thermally crosslinkable polysiloxane solution is preferably an alcohol solvent, particularly preferably a monoalkyl ether derivative of ethylene glycol, diethylene glycol, triethylene glycol, propylene glycol, dipropylene glycol, butanediol, or the like. Specifically, the final solvent is preferably butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol, or the like.

When these solvents are contained as a main component, a non-alcohol solvent can also be added as an auxiliary solvent. Examples of this auxiliary solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, and the like.

Additionally, as another reaction operation using an acid catalyst, water or a water-containing organic solvent is added to the monomer or an organic solution of the monomer to start the hydrolysis reaction. In this event, the catalyst may be added to the monomer or the organic solution of the monomer, or may be added to the water or the water-containing organic solvent. The reaction temperature is 0 to 100°C, preferably 10 to 80°C. A method by heating to 10 to 50°C when adding the water dropwise and thereafter raising the temperature to 20 to 80°C for aging is preferable.

In the case of using the organic solvent, a water-soluble solvent is preferred. Examples thereof include: methanol, ethanol, 1-propanol, 2-propanol, 1-butanol, 2-butanol, 2-methyl-1-propanol, acetone, tetrahydrofuran, acetonitrile; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether; mixtures thereof; and the like.

The organic solvent is preferably used in an amount of 0 to 1,000 ml, particularly 0 to 500 ml, per mol of the monomer. When the organic solvent is used in a smaller amount, a reaction vessel can be made smaller and more economical. The obtained reaction mixture can be subjected to post-treatment in the same manner as described above to obtain the thermally crosslinkable polysiloxane.

### (Synthesis Method 2: Alkali Catalyst)

Additionally, the thermally crosslinkable polysiloxane (Sx) can be produced by hydrolysis condensation of one kind of the hydrolyzable monomer (Sm) or a mixture of two or more kinds thereof in the presence of an alkali catalyst.

Examples of the alkali catalyst used in this event include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethyl monoethanolamine, monomethyl diethanolamine, triethanolamine, diazabicyclooctane, diazabicyclocyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, calcium hydroxide, and the like. The catalyst is used in an amount of 1×10⁻⁶ mol to 10 mol, preferably 1×10⁻⁵ mol to 5 mol, and more preferably 1×10⁻⁴ mol to 1 mol per mol of the silicon monomer.

When the thermally crosslinkable polysiloxane is obtained from the above monomer by the hydrolysis condensation, water is added in an amount of preferably 0.1 to 50 mol per mol of the hydrolyzable substituent bonded to the monomer. When the amount is 50 mol or less, an apparatus used for the reaction can be made small and economical.

As the operation method, the monomer is added to a catalyst aqueous solution to start the hydrolysis condensation reaction. In this event, an organic solvent may be added to the catalyst aqueous solution, or the monomer may be diluted with the organic solvent, or both of these operations may be performed. A reaction temperature is 0 to 100°C, preferably 5 to 80°C. As a preferable method, the temperature is maintained at 5 to 80°C when the monomer is being added dropwise, and then the resultant is aged at 20 to 80°C.

As the organic solvent which can be added to the alkali catalyst aqueous solution or with which the monomer can be diluted, the same organic solvents as the examples of the organic solvents that can be added to the acid catalyst aqueous solution are preferably used. Note that the organic solvent is used in an amount of preferably 0 to 1,000 ml per mol of the monomer because the reaction can be performed economically.

Then, if necessary, neutralization reaction of the catalyst is carried out to obtain a reaction mixture aqueous solution. In this case, the amount of an acidic substance usable for the neutralization is preferably 0.1 to 2 equivalents relative to the alkaline substance used as the catalyst. This acidic substance may be any substance as long as it exhibits acidity in water.

Subsequently, by-products such as alcohol generated by the hydrolysis condensation reaction are preferably removed under reduced pressure or by other techniques from the reaction mixture. In this event, the reaction mixture is heated at a temperature of preferably 0 to 100°C, more preferably 10 to 90°C, and further preferably 15 to 80°C, depending on the kinds of the added organic solvent and the alcohol generated by the reaction. Additionally, a degree of pressure reduction in this event is preferably atmospheric pressure or less, more preferably 80 kPa or less in absolute pressure, and further preferably 50 kPa or less in absolute pressure, that varies depending on the kinds of the organic solvent and alcohol to be removed, as well as an exhaust apparatus, a condensation apparatus, and the heating temperature. Although it is difficult to accurately know the amount of the alcohol to be removed on this occasion, it is preferable to remove about 80% by mass or more of the generated alcohol.

Next, to remove the alkali catalyst used in the hydrolysis condensation, the thermally crosslinkable polysiloxane is extracted with an organic solvent. The preferable organic solvent used in this event is the one capable of dissolving the thermally crosslinkable polysiloxane and causes two-layer separation when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, mixtures thereof, and the like.

Further, it is also possible to use a mixture of a water-soluble organic solvent and a slightly-water-soluble organic solvent.

As specific examples of the organic solvent used for removing the alkali catalyst, it is possible to use the above-described organic solvents and mixtures of the water-soluble organic solvent and the slightly-water-soluble organic solvent, as specifically exemplified for those used for removing the acid catalyst.

Note that a mixing ratio of the water-soluble organic solvent and the slightly-water-soluble organic solvent is selected as appropriate, and the amount of the water-soluble organic solvent is 0.1 to 1,000 parts by mass, preferably 1 to 500 parts by mass, and further preferably 2 to 100 parts by mass relative to 100 parts by mass of the slightly-water-soluble organic solvent.

Subsequently, washing with neutral water is performed. As this water, what is commonly called deionized water or ultrapure water may be used. The amount of this water is 0.01 to 100 L, preferably 0.05 to 50 L, and more preferably 0.1 to 5 L relative to 1 L of the thermally crosslinkable polysiloxane solution. This washing method may be performed by putting both into the same container, stirring and thereafter leaving them to stand to separate an aqueous layer. The washing may be performed one or more times. Since washing ten times or more does not always exert its full washing effect, the washing is preferably performed one to five times or so.

A final solvent is added to the washed thermally crosslinkable polysiloxane solution, and solvent exchange is carried out under reduced pressure, thereby obtaining the desired thermally crosslinkable polysiloxane solution. The temperature during this solvent exchange is preferably 0 to 100°C, more preferably 10 to 90°C, and further preferably 15 to 80°C, depending on the kinds of the extraction solvent to be removed. Additionally, the degree of pressure reduction in this event is preferably atmospheric pressure or less, more preferably 80 kPa or less in absolute pressure, and further preferably 50 kPa or less in absolute pressure, that varies depending on the kind of the extraction solvent to be removed, as well as the exhaust apparatus, the condensation apparatus, and the heating temperature.

The final solvent to be added to the thermally crosslinkable polysiloxane solution is preferably an alcohol solvent, particularly preferably a monoalkyl ether of ethylene glycol, diethylene glycol, triethylene glycol, or the like, or a monoalkyl ether of propylene glycol, dipropylene glycol, or the like. Specifically, the final solvent is preferably propylene glycol monomethyl ether, ethylene glycol monomethyl ether, propylene glycol monoethyl ether, ethylene glycol monoethyl ether, propylene glycol monopropyl ether, ethylene glycol monopropyl ether, diacetone alcohol, or the like.

Additionally, as another reaction operation using an alkali catalyst, water or a water-containing organic solvent is added to the monomer or an organic solution of the monomer to start the hydrolysis reaction. In this event, the catalyst may be added to the monomer or the organic solution of the monomer, or may be added to the water or the water-containing organic solvent. The reaction temperature is 0 to 100°C, preferably 10 to 80°C. A method by heating to 10 to 50°C when adding the water dropwise and thereafter raising the temperature to 20 to 80°C for aging is preferable.

The organic solvent usable as the organic solution of the monomer or the water-containing organic solvent is preferably a water-soluble solvent. Examples thereof include methanol, ethanol, 1-propanol, 2-propanol, 1-butanol, 2-butanol, 2-methyl-1-propanol, acetone, tetrahydrofuran, acetonitrile; polyhydric alcohol condensate derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether; mixtures thereof; and the like.

The molecular weight of the thermally crosslinkable polysiloxane obtained by the above Synthesis Method 1 or 2 can be adjusted not only through the selection of the monomer but also by controlling the reaction conditions during the polymerization. It is preferable to use the thermally crosslinkable polysiloxane having a weight average molecular weight of 100,000 or less, more preferably 200 to 50,000, and further preferably 300 to 30,000. When the weight average molecular weight is 100,000 or less, foreign matters and uneven coating are never caused. Note that data on the above weight average molecular weight indicates the molecular weight in terms of polystyrene determined by gel permeation chromatography (GPC) using RI as a detector, tetrahydrofuran as an eluent, and polystyrene as a reference substance.

Physical properties of the thermally crosslinkable polysiloxane used in the present invention vary depending on the kind of the acid or alkali catalyst used for the hydrolysis condensation and the reaction conditions. Thus, they can be adjusted as appropriate according to intended performance of a metal-containing film.

Furthermore, a polysiloxane derivative can be used as a component of the composition for forming a metal-containing film, where the polysiloxane derivative is produced from a mixture of one or two or more kinds of the hydrolyzable monomer (Sm) and a hydrolyzable metal compound represented by the following general formula (Mm) under the conditions using the acid or alkali catalyst,

**U(OR⁷)ₘ₇(OR⁸)ₘ₈ (Mm)**

wherein R⁷ and R⁸ represent an organic group having 1 to 30 carbon atoms; m7+m8 represents the same number as a valence determined by the kind of U, wherein "m7" and "m8" represent an integer of 0 or more, and U represents an element belonging to the group III, IV, or V in the periodic table, except for carbon and silicon.

Examples of the hydrolyzable metal compound represented by the above general formula (Mm) include certain metal alkoxides of boron, aluminum, gallium, yttrium, germanium, titanium, hafnium, and the like. Specifically, those described in [0107] to [0123] of JP 2020-118960 A are usable.

### <Polycarbosilane (Sy)>

The polycarbosilane preferably contains a repeating unit represented by the following general formula (Sy-1), 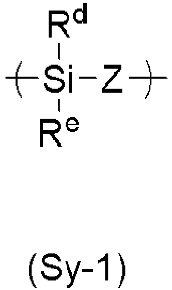 wherein R^{d} and R^{e} each independently represents a hydrogen atom, a hydroxy group, a halogen atom, or a monovalent organic group having 1 to 30 carbon atoms; and Z represents a substituted or unsubstituted divalent hydrocarbon group having 1 to 20 carbon atoms.

Examples of Z in the above general formula (Sy-1) include a substituted or unsubstituted divalent chain hydrocarbon group having 1 to 20 carbon atoms, a substituted or unsubstituted divalent aliphatic cyclic hydrocarbon group having 3 to 20 carbon atoms, and a substituted or unsubstituted divalent aromatic hydrocarbon group having 6 to 20 carbon atoms. Note that in the present description, the chain hydrocarbon group includes both of a linear hydrocarbon group and a branched hydrocarbon group.

Examples of the above-described unsubstituted divalent chain hydrocarbon group having 1 to 20 carbon atoms include chain saturated hydrocarbon groups such as methanediyl and ethanediyl groups, chain unsaturated hydrocarbon groups such as ethenediyl and propenediyl groups, and the like.

Examples of the above-described unsubstituted divalent aliphatic cyclic hydrocarbon group having 3 to 20 carbon atoms include monocyclic saturated hydrocarbon groups such as cyclobutanediyl group, monocyclic unsaturated hydrocarbon groups such as cyclobutenediyl group, polycyclic saturated hydrocarbon groups such as bicyclo[2.2.1]heptanediyl group, polycyclic unsaturated hydrocarbon groups such as bicyclo[2.2.1]heptenediyl group, and the like.

Examples of the above-described unsubstituted divalent aromatic hydrocarbon group having 6 to 20 carbon atoms include phenylene group, biphenylene group, phenylene ethylene group, naphthylene group, and the like.

Examples of the substituent in the substituted divalent chain hydrocarbon group having 1 to 20 carbon atoms, the substituted divalent aliphatic cyclic hydrocarbon group having 3 to 20 carbon atoms, and the substituted divalent aromatic hydrocarbon group having 6 to 20 carbon atoms represented by Z include halogen atom, hydroxy group, cyano group, nitro group, alkoxy group, acyl group, acyloxy group, and the like.

Z preferably represents an unsubstituted chain saturated hydrocarbon group, and more preferably represents a methanediyl group or an ethanediyl group.

Examples of the monovalent organic group having 1 to 30 carbon atoms represented by R^{d} or R^{e} in the above formula (Sy-1) include a monovalent hydrocarbon group having 1 to 30 carbon atoms, preferably 1 to 20 carbon atoms, a monovalent group (α) having a divalent heteroatom-containing group between adjacent carbons of this hydrocarbon group, a monovalent group (β) obtained by substituting some or all of hydrogen atoms in the above hydrocarbon group or the above monovalent group (α) having a divalent heteroatom-containing group with a monovalent heteroatom-containing group, and the like.

Examples of the above-described monovalent hydrocarbon group having 1 to 30 carbon atoms include a monovalent chain hydrocarbon group having 1 to 30 carbon atoms, preferably 1 to 20 carbon atoms, a monovalent alicyclic hydrocarbon group having 3 to 30 carbon atoms, preferably 3 to 20 carbon atoms, and a monovalent aromatic hydrocarbon group having 6 to 30 carbon atoms, preferably 6 to 20 carbon atoms.

Examples of the monovalent chain hydrocarbon group having 1 to 30 carbon atoms include alky groups such as methyl group and ethyl group, alkenyl groups such as ethenyl group, alkynyl groups such as ethynyl group, and the like.

Examples of the above-described monovalent alicyclic hydrocarbon group having 3 to 30 carbon atoms include: monovalent monocyclic alicyclic saturated hydrocarbon groups such as cyclopentyl group and cyclohexyl group; monovalent monocyclic alicyclic unsaturated hydrocarbon groups such as cyclopentenyl group and cyclohexenyl group; monovalent polycyclic alicyclic saturated hydrocarbon groups such as norbornyl group and adamantyl group; monovalent polycyclic alicyclic unsaturated hydrocarbon groups such as norbornenyl group and tricyclodecenyl group; and the like.

Examples of the monovalent aromatic hydrocarbon group having 6 to 30 carbon atoms include: aryl groups such as phenyl group, tolyl group, xylyl group, naphthyl group, methylnaphthyl group, and anthryl group; aralkyl groups such as benzyl group, naphthylmethyl group, and anthrylmethyl group; and the like.

Examples of the heteroatom constituting the divalent or monovalent heteroatom-containing group include oxygen atom, nitrogen atom, sulfur atom, phosphorous atom, silicon atom, halogen atom, and the like. Examples of the halogen atom include fluorine atom, chlorine atom, bromine atom, iodine atom, and the like.

Examples of the divalent heteroatom-containing group include -O-, -CO-, -S-, -CS-, -NR'-, a combination of two or more thereof, and the like. R' represents a hydrogen atom or a monovalent hydrocarbon group.

Examples of the monovalent heteroatom-containing group include halogen atoms such as fluorine atom, chlorine atom, bromine atom, and iodine atom, and groups such as hydroxy group, carboxy group, cyano group, amino group, and sulfanyl group.

As the monovalent organic group having 1 to 30 carbon atoms represented by R^{d} or R^{e}, the monovalent hydrocarbon group is preferred, the monovalent chain hydrocarbon group or the monovalent aromatic hydrocarbon group is more preferred, and an alkyl group or an aryl group is further preferred.

The monovalent organic group represented by R^{d} or R^{e} preferably has one or more and 10 or less carbon atoms, and more preferably has one or more and 6 or less carbon atoms.

Examples of the halogen atom represented by R^{d} or R^{e} include fluorine atom, chlorine atom, bromine atom, iodine atom, and the like. A chlorine atom or a bromine atom is preferred as this halogen atom.

The lower limit of the proportion of the structural unit (Sy-1) is preferably 5 mol%, more preferably 30 mol%, further preferably 60 mol%, and particularly preferably 80 mol%, relative to the whole structural units of the polycarbosilane (Sy). On the other hand, the upper limit of the proportion of the structural unit (Sy-1) is not particularly limited, and may be 100 mol%. The proportion of the structural unit (Sy-1) within the above range enables to further enhance collapse prevention of a resist pattern, resistance to oxygen gas etching, and solvent resistance of a metal-containing film formed from the composition for forming a metal-containing film of the present invention.

The polycarbosilane (Sy) may contain a repeating unit represented by the following formula (Sy-2) and/or the following general formula (Sy-3) in addition to the repeating unit represented by the above general formula (Sy-1).

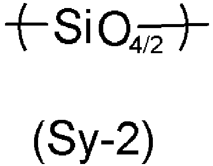

When the polycarbosilane (Sy) contains the repeating unit represented by the above formula (Sy-2), the lower limit of the proportion of the structural unit (Sy-2) is preferably 0.1 mol%, more preferably 1 mol%, and further preferably 5 mol%, relative to the whole structural units of the polycarbosilane (Sy). On the other hand, the upper limit of the proportion of the structural unit (Sy-2) is preferably 50 mol%, more preferably 40 mol%, further preferably 30 mol%, and particularly preferably 20 mol%.

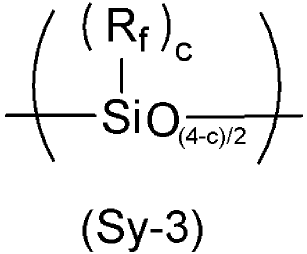

In the above general formula (Sy-3), R_{f} represents a substituted or unsubstituted monovalent hydrocarbon group having 1 to 20 carbon atoms. "c" represents 1 or 2. When "c" represents 2, two R_{f} are identical to or different from each other.

The above "c" preferably represents 1.

Examples of R_{f} include the same groups as the monovalent hydrocarbon groups having 1 to 20 carbon atoms exemplified for R^{d} or R^{e} in the above general formula (Sy-1), etc. Additionally, examples of the substituent in the above-described monovalent hydrocarbon group having 1 to 20 carbon atoms include the same groups as the monovalent heteroatom-containing groups exemplified for R^{d} or R^{e} in the above general formula (Sy-1), etc.

R_{f} preferably represents a substituted or unsubstituted monovalent chain hydrocarbon group, or a substituted or unsubstituted monovalent aromatic hydrocarbon group, more preferably represents an alkyl group or an aryl group, and further preferably represents a methyl group or a phenyl group.

When the polycarbosilane (Sy) has the structural unit (Sy-3), the lower limit of the proportion of the structural unit (Sy-3) is preferably 0.1 mol%, more preferably 1 mol%, and further preferably 5 mol%, relative to the whole structural units of the polycarbosilane (Sy). The upper limit of the proportion of the structural unit (Sy-3) is preferably 50 mol%, more preferably 40 mol%, further preferably 30 mol%, and particularly preferably 20 mol%.

Additionally, the polycarbosilane (Sy) may contain a structural unit having a structure of Si-O-Si formed by dehydration condensation or the like of the hydroxy group represented by R^{d} or R^{e} in the above general formula (Sy-1), in addition to the above structural units.

The preferred solvent for the polycarbosilane is an alcohol solvent or an ether solvent. Particularly preferred as the alcohol solvent is ethylene glycol, diethylene glycol, triethylene glycol, propylene glycol, dipropylene glycol, diacetone alcohol, or the like. Specifically preferred as the ether solvent is propylene glycol monomethyl ether, ethylene glycol monomethyl ether, propylene glycol monoethyl ether, ethylene glycol monoethyl ether, propylene glycol monopropyl ether, ethylene glycol monopropyl ether, or the like.

Additionally, commercially available polycarbosilane can be used in the present invention. For example, polycarbosilane including a unit structure represented by the following formula (Sy-4) (for example, (product name: NIPSY TypeS, produced by NGS Advanced Fibers Co., Ltd. (Mn=2,716 (GPC UV detector/in terms of polystyrene)), product name: NIPSY TypeL (number average molecular weight: 1,000, weight average molecular weight: 4,500), etc. can be used. The polycarbosilane used in the present invention has a weight average molecular weight of preferably 400 to 12,000, more preferably 2,000 to 12,000.

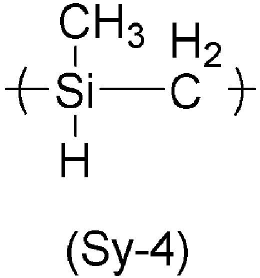

### (Polysilane (Sz))

The polysilane preferably contains a repeating unit represented by the following general formula (Sz-1),

(R⁹R¹⁰R¹¹Si)ₐ₂(R¹²R¹³Si)ₐ₃(R¹⁴Si)ₐ₄(Si)ₐ₅ (Sz-1)

wherein each of R⁹, R¹⁰, R¹¹, R¹², R¹³, and R¹⁴ represents a methyl group, a phenyl group, or a hydroxyl group; and "a2", "a3", "a4", and "a5" each represents a mole fraction, satisfying a2+a3+a4+a5=1, 0≤a2≤1, 0≤a3≤1, 0≤a4≤1, and 0≤a5≤1.

Furthermore, the polysilane may be one or more kinds of polymers selected from a hydrolyzate, a condensate, and a hydrolysis condensate of the above polysilane compound. Additionally, the polysilane may be a hydrolyzate, a condensate, or a hydrolysis condensate with polysiloxane, or may be subjected to hydrolysis condensation with the hydrolyzable monomer (Sm) .

As the polysilane compound represented by the above general formula (Sz-1), OGSOL SI-10-10 (polymethylphenyl silane), SI-10-20 (polymethylphenyl silane), SI-20-10 (polyphenyl silane), SI-20-10 (improved) (polyphenyl silane), SI-30-10 (cyclic polydiphenyl silane), all produced by Osaka Gas Chemicals Co., Ltd., etc. can be used. Furthermore, low-molecular-weight products thereof obtained by reacting them under alkaline conditions may also be used.

Particularly, the polysilane compound represented by the above general formula (Sz-1) preferably has a weight average molecular weight of 1,000 or less. The weight average molecular weight of 1,000 or less enables to easily dissolve a hydrolyzate, a condensate, or a hydrolysis condensate of a mixture containing the polysilane compound represented by the above general formula (Sz-1) in the solvent component of the composition for forming a metal-containing film, thereby preventing generation of particles during film formation.

Here, various solvents can be used for the above reaction under the alkaline conditions. For example, one or more solvents selected from the following can be used: hydrocarbon solvents such as benzene, toluene, and xylene; glycol solvents such as propylene glycol monomethyl ether and propylene glycol monoethyl ether; ether solvents such as diethyl ether, diisopropyl ether, dibutyl ether, tetrahydrofuran, and 1,4-dioxane; ketone solvents such as acetone, methyl ethyl ketone, methyl isobutyl ketone, methyl amyl ketone, cyclopentanone, and cyclohexanone; and alcohol solvents such as ethanol, isopropyl alcohol, and butanol.

Furthermore, various bases can be used as a base to be added. For example, usable bases include: inorganic bases such as sodium hydroxide, potassium hydroxide, barium hydroxide, ammonia, tetramethylammonium hydroxide, sodium carbonate, sodium bicarbonate, potassium carbonate, lithium hydride, sodium hydride, potassium hydride, and calcium hydride; alkyl metals such as methyl lithium, n-butyl lithium, methyl magnesium chloride, and ethyl magnesium bromide; alkoxides such as sodium methoxide, sodium ethoxide, and potassium t-butoxide; and organic bases such as triethyl amine, diisopropyl ethyl amine, N,N-dimethylaniline, pyridine, 4-dimethylaminopyridine, and diazabicyclo undecene (DBU). A reaction temperature falls within a range preferably from -50°C to approximately a boiling point of the solvent, and further preferably from a room temperature to 100°C.

The hydrolysis, condensation, or hydrolysis condensation reaction can be carried out using, as an acid catalyst, one or more compounds selected from inorganic acids, aliphatic sulfonic acids, and aromatic sulfonic acids. Examples of the acid catalyst used in this event include hydrofluoric acid, hydrochloric acid, hydrobromic acid, sulfuric acid, nitric acid, perchloric acid, phosphoric acid, methanesulfonic acid, benzenesulfonic acid, toluenesulfonic acid, and the like. The catalyst is used in an amount of preferably 10⁻⁶ to 10 mol, more preferably 10⁻⁵ to 5 mol, and further preferably 10⁻⁴ to 1 mol per mol of the monomer (polysilane compound).

When the polymer is synthesized by the hydrolysis condensation of such monomer, water is added in an amount of preferably 0.01 to 100 mol, more preferably 0.05 to 50 mol, and further preferably 0.1 to 30 mol per mol of the hydrolyzable substituent bonded to the monomer. The addition amount of 100 mol or less is economical because an apparatus used for the reaction does not become too large. Furthermore, when the addition amount is 0.01 mol or more, the reaction progresses.

As the operation method, the monomer can be added to a catalyst aqueous solution to start the hydrolysis condensation reaction. In this event, an organic solvent may be added to the catalyst aqueous solution, or the monomer may be diluted with the organic solvent, or both of these operations may be performed. A reaction temperature is preferably 0 to 100°C, more preferably 5 to 80°C. As a preferable method, the temperature is maintained at 5 to 80°C when the monomer is being added dropwise, and then the resultant is aged at 20 to 80°C.

The organic solvent which can be added to the catalyst aqueous solution or with which the monomer can be diluted is preferably methanol, ethanol, 1-propanol, 2-propanol, 1-butanol, 2-butanol, 2-methyl-1-propanol, acetone, acetonitrile, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, mixtures thereof, or the like.

Among these solvents, water-soluble solvents are more preferable. Examples thereof include: alcohols such as methanol, ethanol, 1-propanol, and 2-propanol; polyhydric alcohols such as ethylene glycol and propylene glycol; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone, acetonitrile, tetrahydrofuran, and the like. Among these, particularly preferred is the one having a boiling point of 100°C or less.

Note that the organic solvent is used preferably in an amount of 0 to 1,000 mL, particularly preferably in an amount of 0 to 500 mL, per mol of the monomer. It is economical that the organic solvent is used in the amount of 1,000 mL or less, because a reaction vessel does not become too large.

Then, if necessary, neutralization reaction of the catalyst is carried out to remove alcohol generated by the hydrolysis condensation reaction under reduced pressure, thereby obtaining a reaction mixture aqueous solution. In this case, the amount of a basic substance usable for the neutralization is preferably 0.1 to 2 equivalents relative to the acid used as the catalyst. This basic substance may be any substance as long as it exhibits alkalinity in water.

Subsequently, by-products such as alcohol generated by the hydrolysis condensation reaction are preferably removed from the reaction mixture. In this event, the reaction mixture is heated at a temperature of preferably 0 to 100°C, more preferably 10 to 90°C, and further preferably 15 to 80°C, depending on the kinds of the added organic solvent, the alcohol generated by the reaction, etc. Additionally, a degree of pressure reduction in this event is preferably atmospheric pressure or less, more preferably 80 kPa or less in absolute pressure, and further preferably 50 kPa or less in absolute pressure, that varies depending on the kinds of the organic solvent, alcohol, etc. to be removed, as well as an exhaust apparatus, a condensation apparatus, and the heating temperature. Although it is difficult to accurately know the amount of the alcohol to be removed on this occasion, it is preferable to remove about 80% by mass or more of the generated alcohol, etc.

Next, the acid catalyst used in the hydrolysis condensation may be removed from the reaction mixture. As a method for removing the acid catalyst, the polymer is mixed with water and extracted with an organic solvent. The preferable organic solvent used in this event is the one capable of dissolving the polymer and causes two-layer separation when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, tert-butyl propionate, propylene glycol mono-t-butyl ether acetate, γ-butyrolactone, methyl isobutyl ketone, cyclopentyl methyl ether, and mixtures thereof.

Further, it is also possible to use a mixture of a water-soluble organic solvent and a slightly-water-soluble organic solvent. For example, preferred combinations include, but are not limited to, methanol+ethyl acetate, ethanol+ethyl acetate, 1-propanol+ethyl acetate, 2-propanol+ethyl acetate, butanediol monomethyl ether+ethyl acetate, propylene glycol monomethyl ether+ethyl acetate, ethylene glycol monomethyl ether+ethyl acetate, butanediol monoethyl ether+ethyl acetate, propylene glycol monoethyl ether+ethyl acetate, ethylene glycol monoethyl ether+ethyl acetate, butanediol monopropyl ether+ethyl acetate, propylene glycol monopropyl ether+ethyl acetate, ethylene glycol monopropyl ether+ethyl acetate, methanol+methyl isobutyl ketone, ethanol+methyl isobutyl ketone, 1-propanol+methyl isobutyl ketone, 2-propanol+methyl isobutyl ketone, propylene glycol monomethyl ether+methyl isobutyl ketone, ethylene glycol monomethyl ether+methyl isobutyl ketone, propylene glycol monoethyl ether+methyl isobutyl ketone, ethylene glycol monoethyl ether+methyl isobutyl ketone, propylene glycol monopropyl ether+methyl isobutyl ketone, ethylene glycol monopropyl ether+methyl isobutyl ketone, methanol+cyclopentyl methyl ether, ethanol+cyclopentyl methyl ether, 1-propanol+cyclopentyl methyl ether, 2-propanol+cyclopentyl methyl ether, propylene glycol monomethyl ether+cyclopentyl methyl ether, ethylene glycol monomethyl ether+cyclopentyl methyl ether, propylene glycol monoethyl ether+cyclopentyl methyl ether, ethylene glycol monoethyl ether+cyclopentyl methyl ether, propylene glycol monopropyl ether+cyclopentyl methyl ether, ethylene glycol monopropyl ether+cyclopentyl methyl ether, methanol+propylene glycol methyl ether acetate, ethanol+propylene glycol methyl ether acetate, 1-propanol+propylene glycol methyl ether acetate, 2-propanol+propylene glycol methyl ether acetate, propylene glycol monomethyl ether+propylene glycol methyl ether acetate, ethylene glycol monomethyl ether+propylene glycol methyl ether acetate, propylene glycol monoethyl ether+propylene glycol methyl ether acetate, ethylene glycol monoethyl ether+propylene glycol methyl ether acetate, propylene glycol monopropyl ether+propylene glycol methyl ether acetate, ethylene glycol monopropyl ether+propylene glycol methyl ether acetate, and the like.

Note that the mixing ratio of the water-soluble organic solvent and the slightly-water-soluble organic solvent is selected as appropriate, and the amount of the water-soluble organic solvent is preferably 0.1 to 1,000 parts by mass, more preferably 1 to 500 parts by mass, and further preferably 2 to 100 parts by mass relative to 100 parts by mass of the slightly-water-soluble organic solvent.

Subsequently, washing with neutral water may be performed. As this water, what is commonly called deionized water or ultrapure water may be used. The amount of this water is preferably 0.01 to 100 L, more preferably 0.05 to 50 L, and further preferably 0.1 to 5 L, relative to 1 L of the polymer solution. This washing method may be performed by putting both into the same container, stirring and thereafter leaving them to stand to separate an aqueous layer. The washing may be performed one or more times. Since washing ten times or more does not exert its full washing effect, the washing is preferably performed one to five times or so.

In this water-washing operation, a part of the polymer escapes into the aqueous layer, so that substantially the same effect as a fractionation operation may be obtained. Therefore, the number of times of the water-washing and the amount of the washing water may be selected as appropriate in view of the catalyst removal effect and the fractionation effect.

Other methods for removing the acid catalyst include a method using an ion-exchange resin, and a method in which the acid catalyst is removed after neutralization with an epoxy compound such as ethylene oxide and propylene oxide. These methods can be selected as appropriate according to the acid catalyst used in the reaction.

To either the polymer with the acid catalyst still remaining or the polymer solution with the acid catalyst removed, a final solvent can be added to perform solvent exchange under reduced pressure, thereby obtaining the polymer solution. The temperature during this solvent exchange is preferably 0 to 100°C, more preferably 10 to 90°C, and further preferably 15 to 80°C, depending on the kinds of the reaction solvent and the extraction solvent to be removed. Additionally, the degree of pressure reduction in this event is preferably atmospheric pressure or less, more preferably 80 kPa or less in absolute pressure, and further preferably 50 kPa or less in absolute pressure, that varies depending on the kind of the extraction solvent to be removed, as well as the exhaust apparatus, the condensation apparatus, and the heating temperature.

In this event, the polymer may become unstable due to changing of the solvent. This is caused by compatibility between the final solvent and the polymer. To prevent this phenomenon, monohydric, dihydric, or polyhydric alcohol containing a cyclic ether as a substituent, or an ether compound may be added as a stabilizer. The addition amount is preferably 0 to 25 parts by mass, more preferably 0 to 15 parts by mass, and further preferably 0 to 5 parts by mass, relative to 100 parts by mass of the polymer in the solution before the solvent exchange. The amount (if added) is preferably 0.5 parts by mass or more. If necessary, the stabilizer may be added to the solution before the solvent exchange to perform the solvent exchange operation.

Furthermore, the concentration of the polymer is preferably 0.1 to 20% by mass. With such concentration, the polymer never undergoes the condensation reaction to change into an insoluble state in an organic solvent. Additionally, such concentration is economical as it requires only the proper amount of the solvent.

The final solvent to be added to the polymer is preferably an alcohol solvent, particularly preferably a monoalkyl ether derivative of ethylene glycol, diethylene glycol, triethylene glycol, propylene glycol, dipropylene glycol, butanediol, or the like. Specifically, the final solvent is preferably butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, or the like.

When these solvents are contained as a main component, a non-alcohol solvent can also be added as an auxiliary solvent. Examples of this auxiliary solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, and the like.

Additionally, as another reaction operation, water or a water-containing organic solvent may be added to the monomer or an organic solution of the monomer to start the hydrolysis reaction. In this event, the acid catalyst may be added to the monomer or the organic solution of the monomer, or may be added to the water or the water-containing organic solvent. The reaction temperature is preferably 0 to 100°C, more preferably 10 to 80°C. A method by heating to 10 to 50°C when adding the water dropwise and thereafter raising the temperature to 20 to 80°C for aging is preferable.

When the organic solvent is used, a water-soluble solvent is preferred. Examples thereof include: methanol, ethanol, 1-propanol, 2-propanol, 1-butanol, 2-butanol, 2-methyl-1-propanol, acetone, tetrahydrofuran, acetonitrile; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether; mixtures thereof; and the like.

In this event, the organic solvent may be used in the same amount as described above. The reaction mixture thus obtained can be subjected to post-treatment in the same manner as described above, thereby obtaining the polymer.

Furthermore, the hydrolysis, condensation, or hydrolysis condensation reaction for synthesizing the polymer can also be carried out using a basic catalyst. Examples of the basic catalyst used in this case include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethyl monoethanolamine, monomethyl diethanolamine, triethanolamine, diazabicyclooctane, diazabicyclocyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, calcium hydroxide, and the like. The catalyst may be used in the same amount as in the above case of using the acid catalyst.

When the polymer is obtained from such monomer, water is preferably added in an amount of 0.1 to 50 mol per mol of the hydrolyzable substituent bonded to the monomer. The addition amount of 50 mol or less is economical because an apparatus used for the reaction does not become too large. When the addition amount is 0.1 mol or more, the reaction progresses.

The operation method of the reaction may be the same as in the above case of using the acid catalyst.

As the organic solvent which can be added to the catalyst aqueous solution or with which the monomer can be diluted, the same as those used in the above case of using the acid catalyst are preferably used. Note that the organic solvent is preferably used in an amount of 0 to 1,000 mL per mol of the monomer. Such amount is economical because a reaction vessel does not become too large.

Then, if necessary, neutralization reaction of the catalyst is carried out to remove alcohol generated by the hydrolysis condensation reaction under reduced pressure, thereby obtaining a reaction mixture aqueous solution. In this case, the amount of an acidic substance usable for the neutralization is preferably 0.1 to 2 equivalents relative to the basic substance used as the catalyst. This acidic substance may be any substance as long as it exhibits acidity in water.

Subsequently, by-products such as alcohol generated by the hydrolysis condensation reaction are preferably removed from the reaction mixture. In this event, the temperature for heating the reaction mixture and the degree of pressure reduction may be the same as in the above case of using the acid catalyst.

Next, the basic catalyst used for the hydrolysis condensation may be removed from the reaction mixture. As the organic solvent used for removing the basic catalyst, the same as those in the above case of using the acid catalyst can be used. Alternatively, it is also possible to remove the basic catalyst using the same mixture of the water-soluble organic solvent and the slightly-water-soluble organic solvent as in the above case of using the acid catalyst. Note that the mixing ratio of the water-soluble organic solvent and the slightly-water-soluble organic solvent may also be the same as the ratio in the above case of using the acid catalyst.

Subsequently, washing with neutral water may be performed. The washing method may be the same as in the above case of using the acid catalyst.

To the washed polymer, a final solvent can be added to perform solvent exchange under reduced pressure, thereby obtaining the polymer solution. The temperature during the solvent exchange and the degree of pressure reduction may be the same as in the above case of using the acid catalyst.

Further in this event, monohydric, dihydric, or polyhydric alcohol containing a cyclic ether as a substituent, or an ether compound may be added as a stabilizer similar to the above case of using the acid catalyst. Additionally, the polymer solution preferably has a concentration of 0.1 to 20% by mass.

The final solvent to be added to the polymer is preferably an alcohol solvent or an ether solvent. Particularly preferred as the alcohol solvent is ethylene glycol, diethylene glycol, triethylene glycol, propylene glycol, dipropylene glycol, or the like. Specifically preferred as the ether solvent is propylene glycol monomethyl ether, ethylene glycol monomethyl ether, propylene glycol monoethyl ether, ethylene glycol monoethyl ether, propylene glycol monopropyl ether, ethylene glycol monopropyl ether, or the like.

When these solvents are contained as a main component, a non-alcohol solvent can also be added as an auxiliary solvent. As this auxiliary solvent, the same auxiliary solvent as in the above case of using the acid solvent can be used.

Additionally, as another reaction operation, water or a water-containing organic solvent may be added to the monomer or an organic solution of the monomer to start the hydrolysis reaction. In this event, the basic catalyst may be added to the monomer or the organic solution of the monomer, or may be added to the water or the water-containing organic solvent. The reaction temperature is preferably 0 to 100°C, more preferably 10 to 80°C. A method by heating to 10 to 50°C when adding the water dropwise and thereafter raising the temperature to 20 to 80°C for aging is preferable.

When the organic solvent is used, a water-soluble solvent is preferred. Examples thereof include methanol, ethanol, 1-propanol, 2-propanol, 1-butanol, 2-butanol, 2-methyl-1-propanol, acetone, tetrahydrofuran, acetonitrile; polyhydric alcohol condensate derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether; mixtures thereof; and the like.

In this event, the organic solvent may be used in the same amount as described above. The reaction mixture thus obtained can be subjected to post-treatment in the same manner as described above, thereby obtaining the polymer.

The molecular weight of the polymer obtained by the reaction as described above can be adjusted not only through the selection of the monomer but also by controlling the reaction conditions during the polymerization. The molecular weight of the polymer thus obtained is not particularly limited, but the polymer for use has a weight average molecular weight of preferably 100,000 or less, more preferably 200 to 50,000, and further preferably 300 to 30,000. By using the polymer having the weight average molecular weight of 100,000 or less, it is possible to prevent foreign matters and uneven coating from occurring. Note that data on the above weight average molecular weight indicates the molecular weight in terms of polystyrene determined by gel permeation chromatography (GPC) using RI as a detector, tetrahydrofuran as an eluent, and polystyrene as a reference substance.

The proportion of the silicon-containing polymer (A) in the composition for forming a metal-containing film of the present invention is not particularly limited. For example, it can be 0.1 to 20 parts by mass, preferably 0.2 to 5 parts by mass, and more preferably 0.5 to 2 parts by mass relative to 100 parts by mass of the organic solvent (C).

### <(B) Metal Source>

The metal source (B) contained in the composition for forming a metal-containing film of the present invention is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, preferably 1 to 20 carbon atoms, or a complex of the metal with a β-diketone.

Preferred examples of the carboxylic acid salt are illustrated below.

Ti⁴⁺(R¹COO⁻)₄ Ti⁴⁺(R²(COO⁻)₂)₂ Ti⁴⁺R⁴(COO⁻)₄

Cr²⁺(R¹COO⁻)₂ Cr²⁺R²(COO⁻)₂

Cr³⁺(R¹COO⁻)₃ (Cr³⁺)₂(R²(COO⁻)₂)₃ Cr³⁺(R¹COO⁻)(OH)₂ (Cr³⁺)₂(R³(COO⁻)₃)₂

Mn²⁺(R¹COO⁻)₂ Mn²⁺R²(COO⁻)₂ Mn³⁺(R¹COO⁻)₃ (Mn³⁺)₂(R²(COO⁻)₂)₃

Fe²⁺R²(COO⁻)₂ Fe³⁺(R¹COO⁻)₃ (Fe³⁺)₂(R²(COO⁻)₂)₃ Fe³⁺R³(COO⁻)₃ Fe²⁺(R¹COO⁻)₂

Co²⁺(R¹COO⁻)₂ Co²⁺R²(COO⁻)₂

Ni²⁺(R¹COO⁻)₂ Ni²⁺R²(COO⁻)₂

Cu⁺R¹COO⁻ (Cu⁺)₂R²(COO⁻)₂ Cu²⁺(R¹COO⁻)₂ Cu²⁺R²(COO⁻)₂

Zn⁺R¹COO⁻ (Zn⁺)₂R²(COO⁻)₂ Zn²⁺(R¹COO⁻)₂

Zr⁴⁺(R¹COO⁻)₄ Zr⁴⁺(R²(COO⁻)₂)₂ Zr⁴⁺R⁴(COO⁻)₄

Mo⁴⁺(R¹COO⁻)₄

In³⁺(R¹COO⁻)₃ (In³⁺)₂(R²(COO⁻)₂)₃ In³⁺R³(COO⁻)₃

Sn²⁺(R¹COO⁻)₂ Sn²⁺R²(COO⁻)₂ Sn⁴⁺(R¹COO⁻)₄ Sn⁴⁺(R²(COO⁻)₂)₂ Sn⁴⁺R⁴(COO⁻)₄

Hf⁴⁺(R¹COO⁻)₄ Hf⁴⁺(R²(COO⁻)₂)₂ Hf⁴⁺R⁴(COO⁻)₄

Bi³⁺(R¹COO⁻)₃ (Bi³⁺)₂(R²(COO⁻)₂)₃ Bi³⁺R³(COO⁻)₃

(In the formulae, R¹ may be identical to or different from each other, and represents hydrogen atom, linear, branched, or cyclic alkyl group having 1 to 30 carbon atoms, preferably 1 to 20 carbon atoms, alkenyl group having 2 to 30 carbon atoms, preferably 2 to 20 carbon atoms, alkynyl group having 2 to 30 carbon atoms, preferably 2 to 20 carbon atoms, or aryl group having 6 to 30 carbon atoms, preferably 6 to 20 carbon atoms, each of these optionally having a hydroxy group, ether group, ester group, amino group, amide group, sulfonic acid ester group, halogen atom, cyano group, nitro group, carbonate group, carbamate group, thiol group, sulfide group, thioketone group, or heteroaromatic ring; R² represents a single bond, or a linear, branched, or cyclic alkylene group, alkenylene group, or alkynylene group each having 1 to 30 carbon atoms, preferably 1 to 20 carbon atoms, or an arylene group having 6 to 30 carbon atoms, preferably 6 to 20 carbon atoms, each of these optionally having a hydroxy group, ether group, ester group, amino group, amide group, sulfonic acid ester group, halogen atom, cyano group, nitro group, carbonate group, carbamate group, thiol group, sulfide group, thioketone group, or heteroaromatic ring; R³ represents a group obtained by removing one hydrogen atom from the alkylene group, arylene group, alkenylene group, or alkynylene group of the R²; and R⁴ represents a group obtained by removing two hydrogen atoms from the alkylene group, arylene group, alkenylene group, or alkynylene group of the R².)

Specific examples of carboxylic acid ions for forming the carboxylic acid salt in the above general formulae are illustrated below.

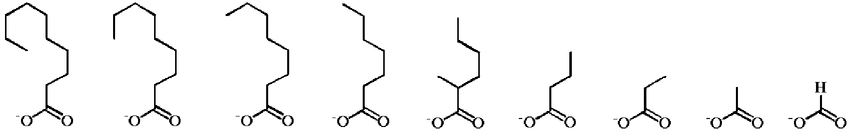

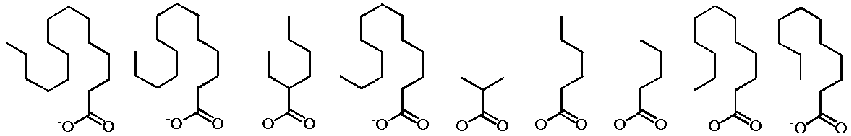

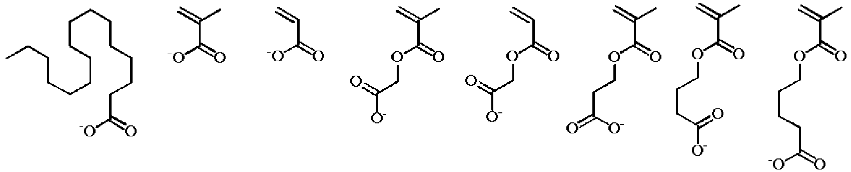

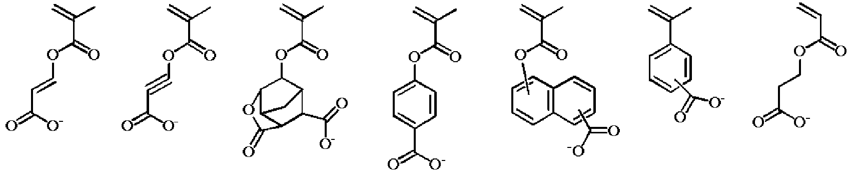

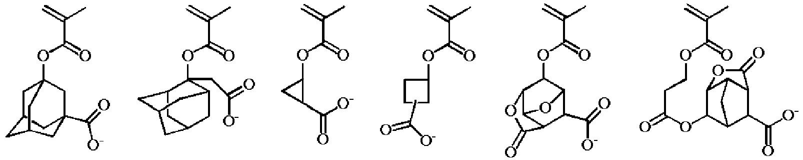

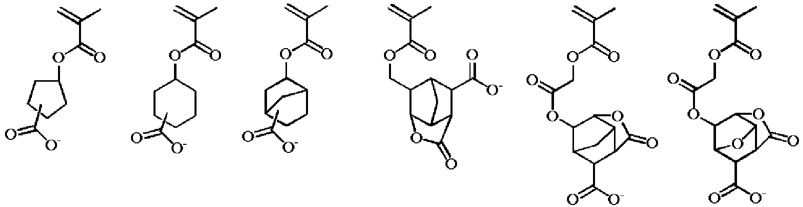

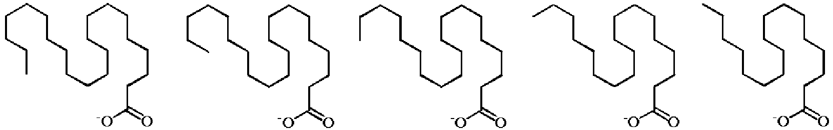

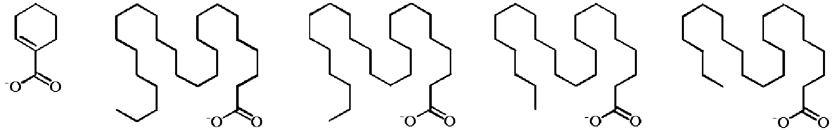

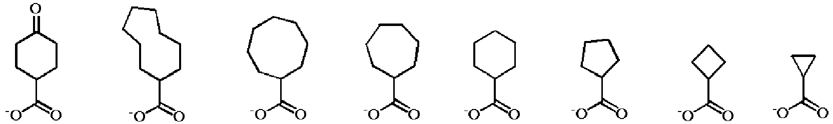

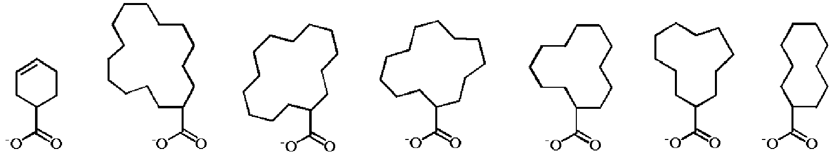

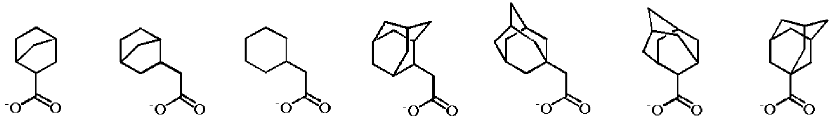

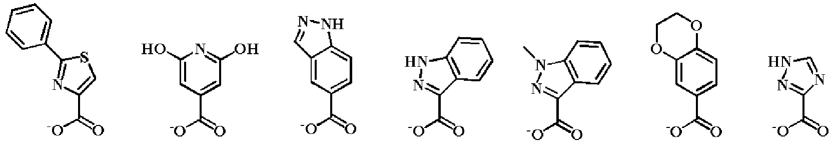

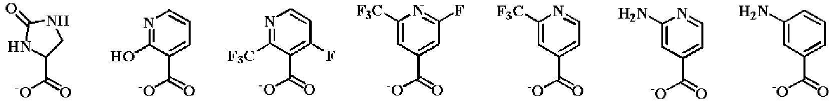

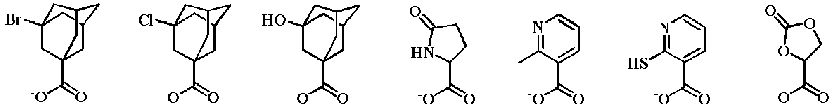

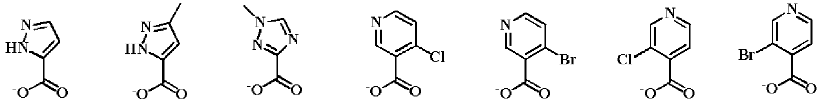

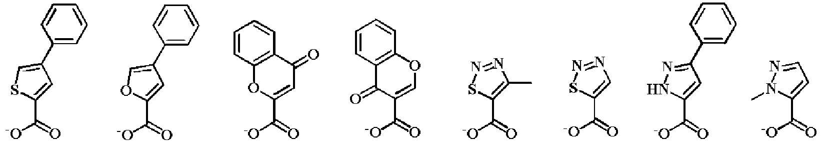

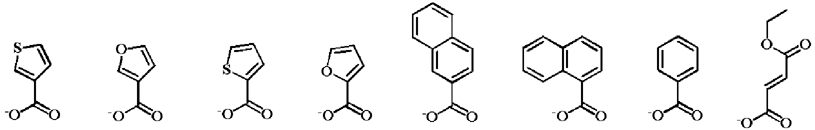

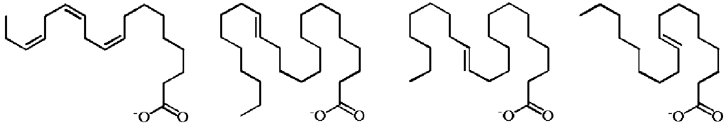

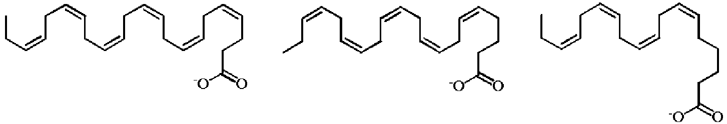

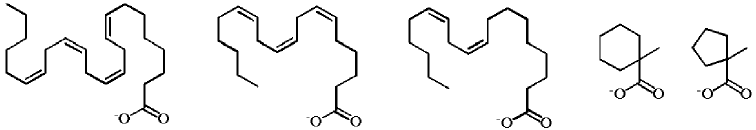

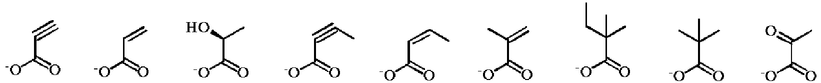

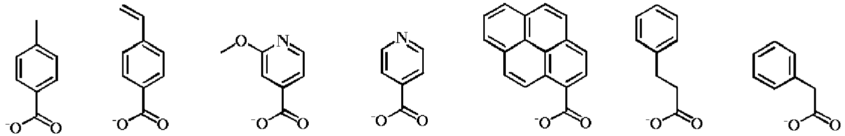

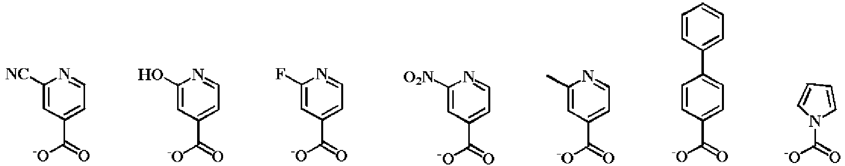

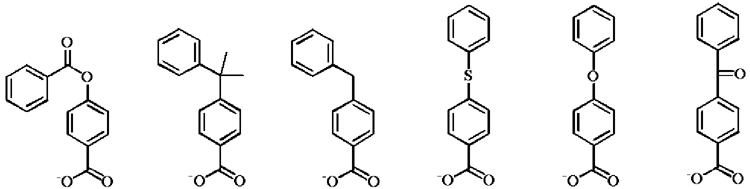

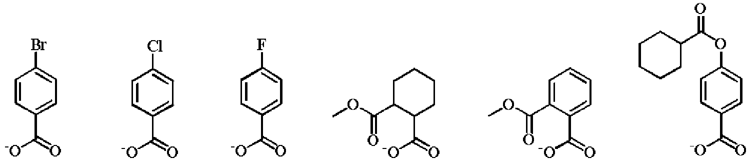

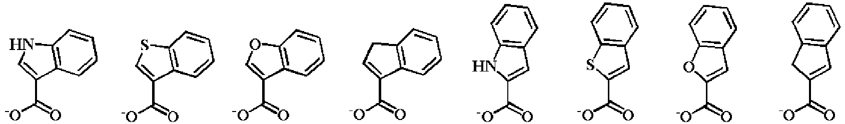

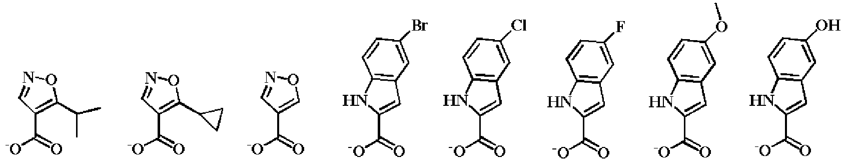

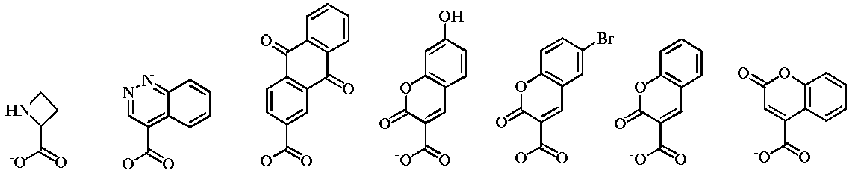

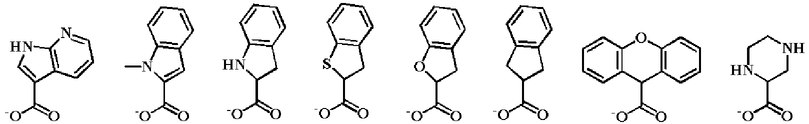

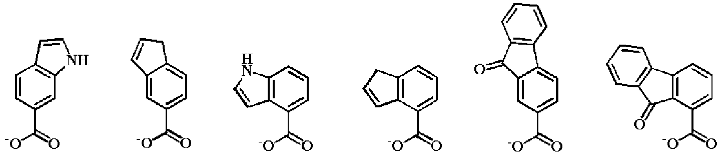

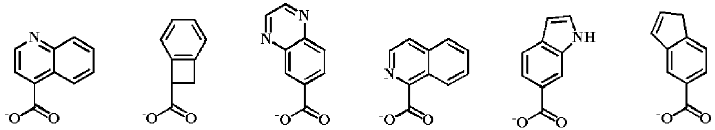

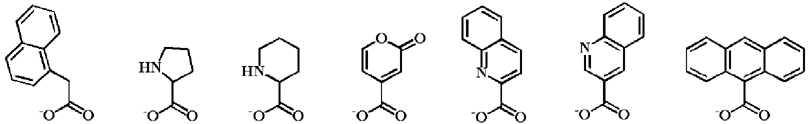

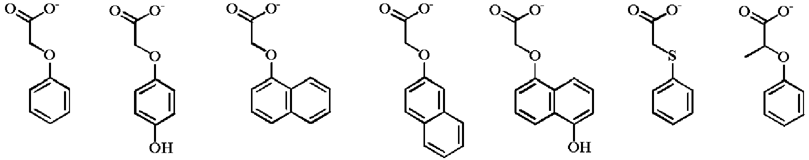

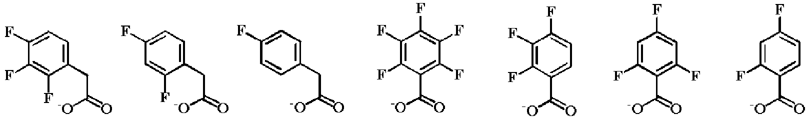

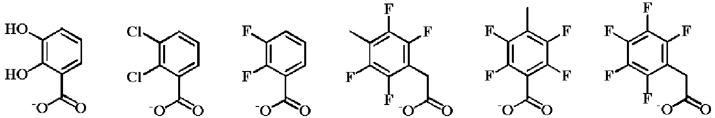

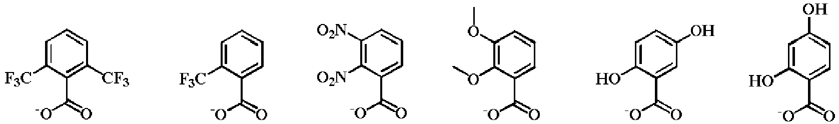

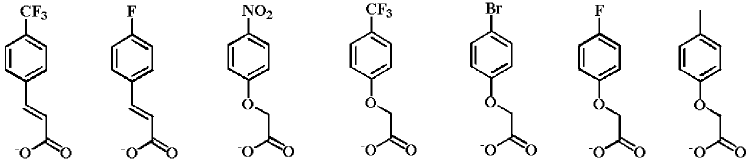

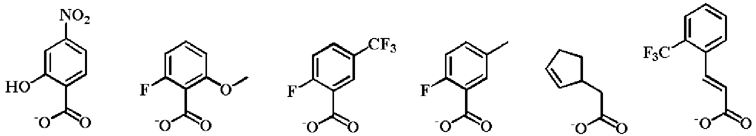

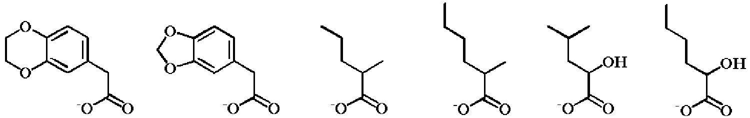

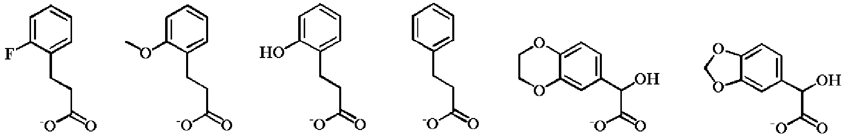

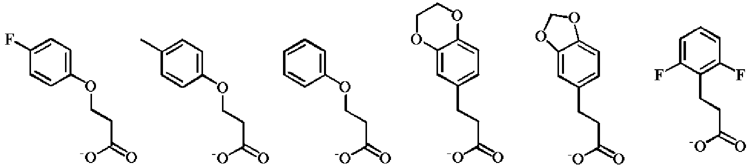

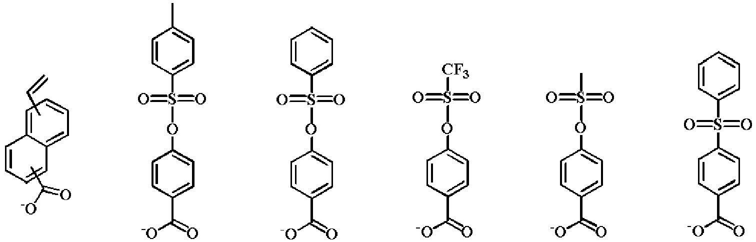

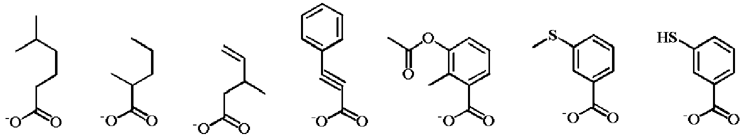

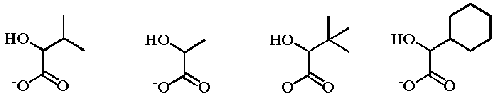

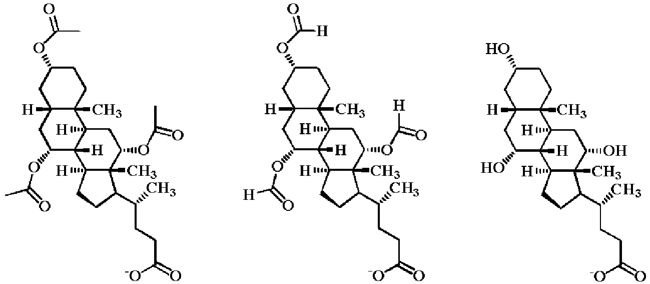

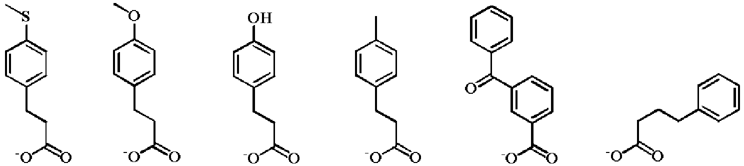

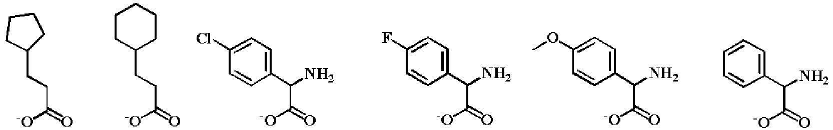

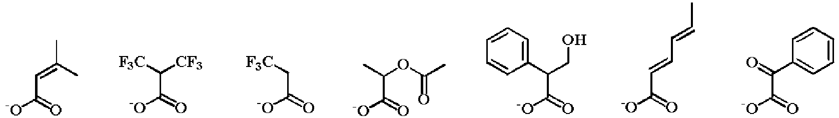

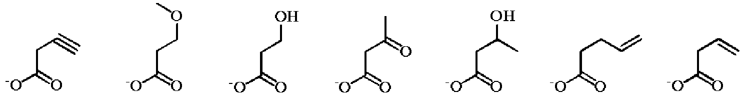

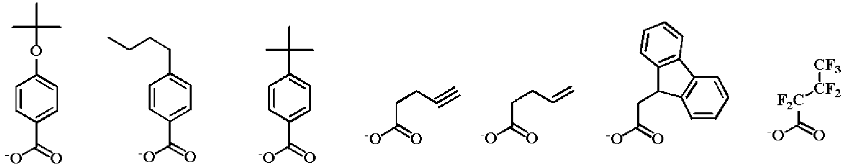

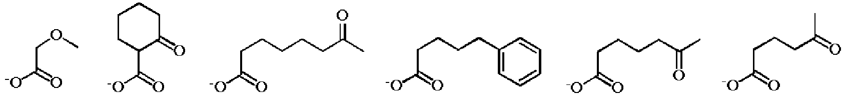

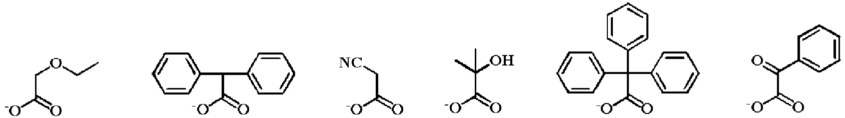

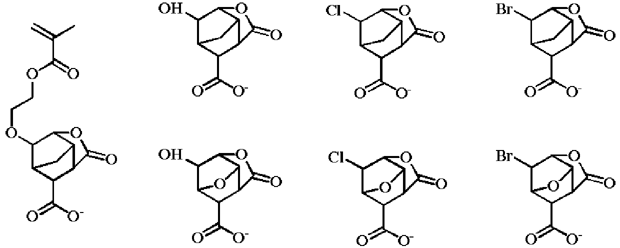

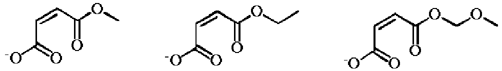

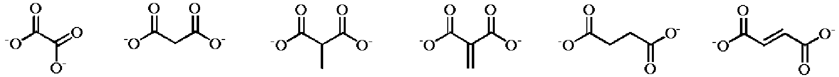

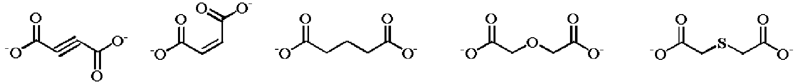

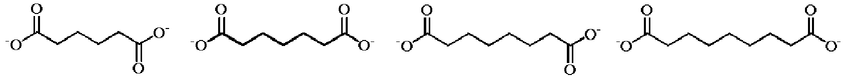

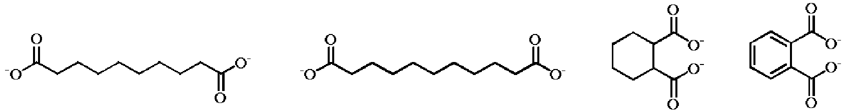

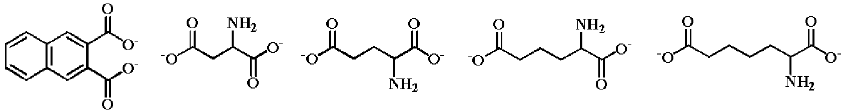

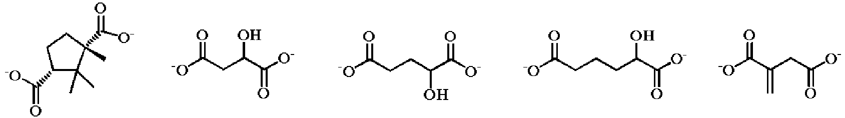

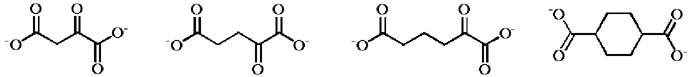

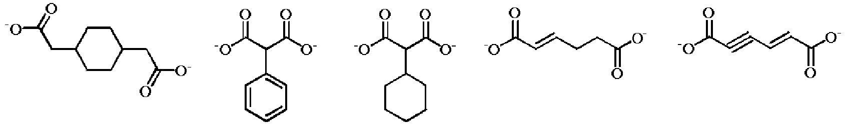

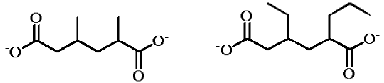

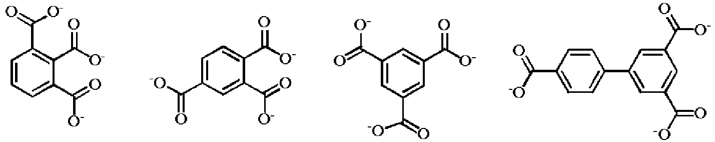

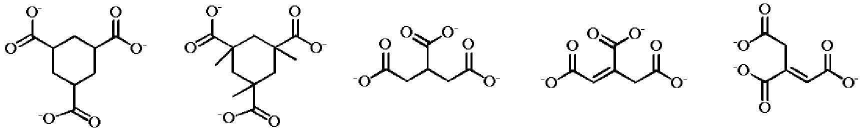

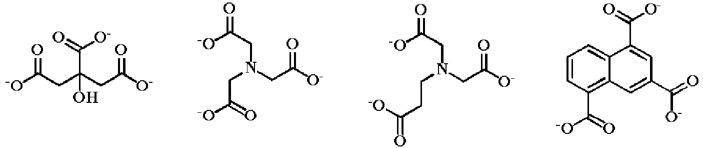

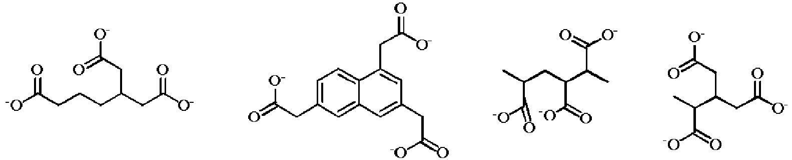

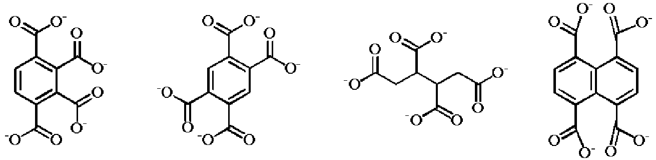

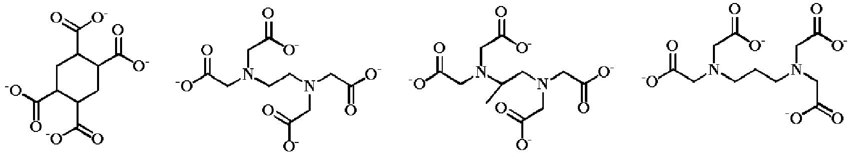

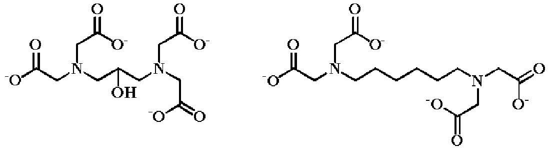

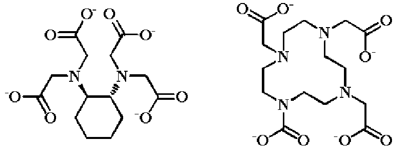

For the carboxylic acid ions for forming the carboxylic acid salt as described above, the carboxylic acid preferably has more carbon atoms as it is more easily dissolved in an organic solvent. Furthermore, if the carboxylic acid does not have too many carbon atoms, a shrinking amount is reduced upon formation of a resist film, and an amount of an outgas composition is also reduced. From the above-described viewpoints, the carboxylic acid ion is more preferably a linear or branched alkyl group having 3 to 10 carbon atoms.

Preferred examples of the β-diketone complex are illustrated below.

**Ti⁴⁺(R¹COCH₂COR²)⁻₄**

**Cr²⁺(R¹COCH₂COR²)⁻₂ Cr³⁺(R¹COCH₂COR²)⁻₃**

**Mn²⁺(R¹COCH₂COR²)⁻₂ Mn³⁺(R¹COCH₂COR²)⁻₃**

**Fe²⁺(R¹COCH₂COR²)⁻₂ Fe³⁺(R¹COCH₂COR²)⁻₃**

**Co²⁺(R¹COCH₂COR²)⁻₂**

**Ni²⁺(R¹COCH₂COR²)⁻₂**

**Cu⁺(R¹COCH₂COR²)⁻ Cu²⁺(R¹COCH₂COR²)**⁻**₂**

**Zn⁺(R¹COCH₂COR²)⁻ Zn²⁺(R¹COCH₂COR²)**⁻**₂**

**Zr⁴⁺(R¹COCH₂COR²)**⁻**₄**

**Mo⁴⁺(R¹COCH₂COR²)⁻₄**

**In³⁺(R¹COCH₂COR²)⁻₃**

**Sn²⁺(R¹COCH₂COR²)⁻₂ Sn⁴⁺(R¹COCH₂COR²)⁻₄**

**Hf⁴⁺(R¹COCH₂COR²)**⁻**₄**

**Bi³⁺(R¹COCH₂COR²)**⁻**₃**

(In the formulae, R¹ and R² may be identical to or different from each other, and represent linear, branched, or cyclic alkyl group having 1 to 20 carbon atoms, alkenyl group having 2 to 20 carbon atoms, alkynyl group having 2 to 20 carbon atoms, or aryl group having 6 to 20 carbon atoms, each of these optionally having a hydroxy group, alkoxy group, ether group, ester group, amino group, amide group, sulfonic acid ester group, halogen atom, cyano group, nitro group, carbonate group, carbamate group, thiol group, sulfide group, thioketone group, or heteroaromatic ring.)

The β-diketone in the above general formulae is substituted or unsubstituted acetylacetone, and specific examples thereof are illustrated below.

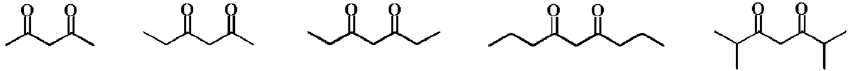

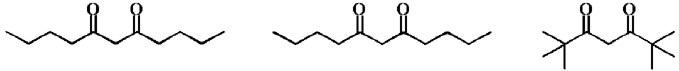

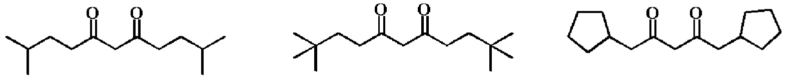

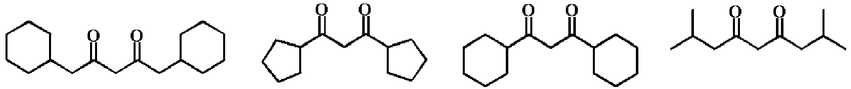

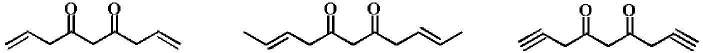

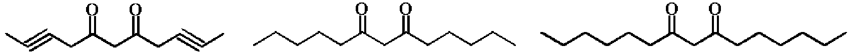

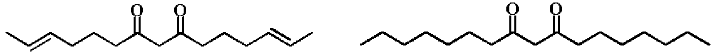

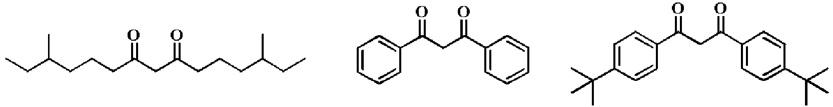

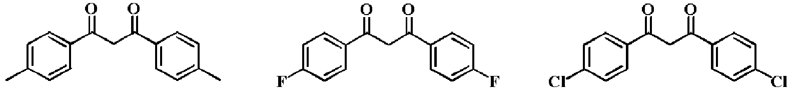

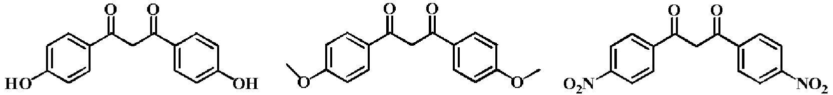

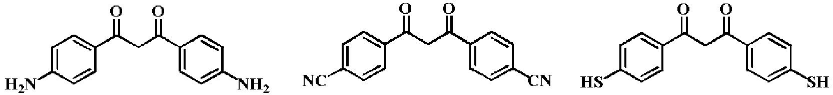

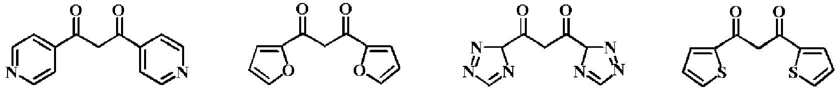

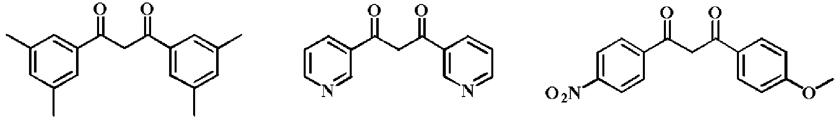

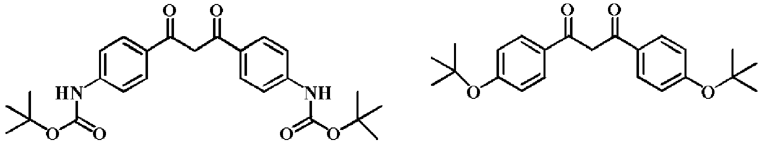

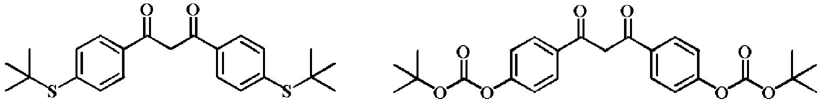

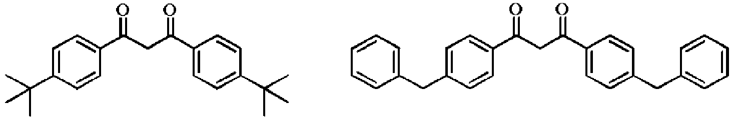

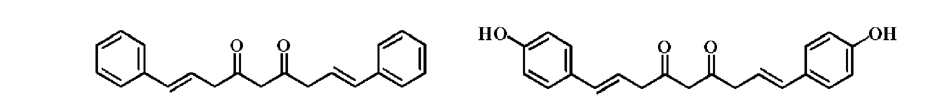

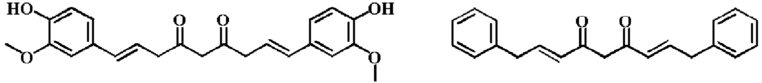

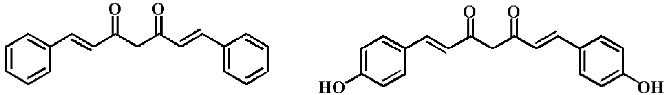

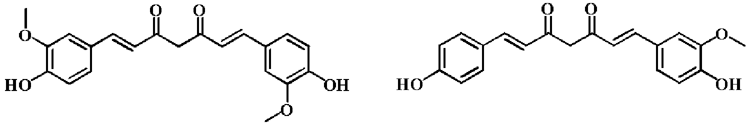

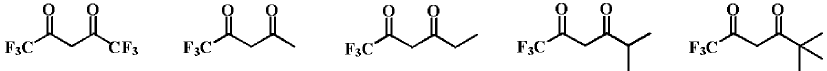

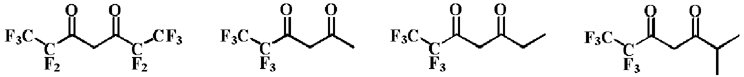

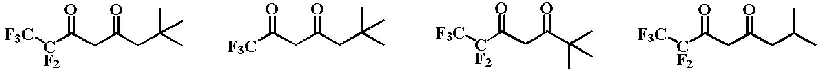

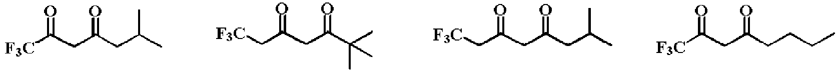

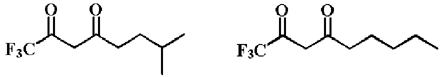

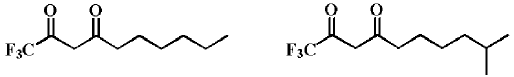

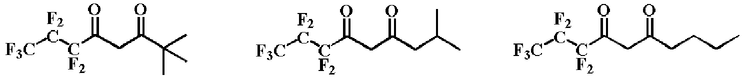

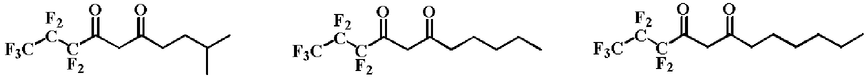

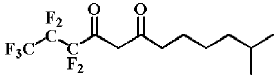

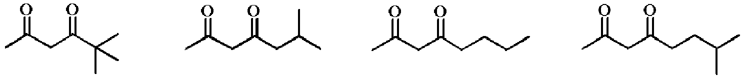

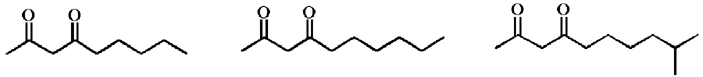

In a β-diketone, R¹ and R² are generally identical to each other. However, R¹ and R² may be different from each other as described in JP 2004-175755 A. The most common is acetylacetone in which both of R¹ and R² represent a methyl group, though it has disadvantage of poor solubility in an organic solvent. R¹ and R² preferably have a total of 3 or more carbon atoms, more preferably have a total of 4 or more carbon atoms.

It is preferable that a hydrogen atom of acetylacetone is substituted and the substituent has more carbon atoms as it is more easily dissolved in an organic solvent. The more carbon atoms the substituent has, the more improved the uniformity of film thickness is when the composition for forming a metal-containing film is spin-coated. Furthermore, if the carboxylic acid does not have too many carbon atoms, a shrinking amount is reduced upon formation of a resist film, and an amount of an outgas composition is also reduced.

Acetylacetone undergoes enolization to form a complex with a metal as shown below.

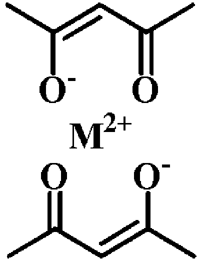

From the viewpoints of solubility in a solvent and availability of raw materials, the metal source (B) used in the composition for forming a metal-containing film of the present invention is preferably a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms. Specifically, the metal source (B) more preferably has a structure represented by the following formula (B-1). 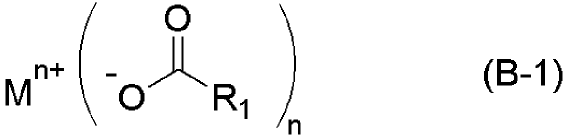 (In the formula, M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.)

From the viewpoints of solubility in an organic solvent, an amount of an outgas composition during baking, and productivity, R₁ in the above formula (B-1) more preferably represents a saturated or unsaturated hydrocarbon group having 1 to 10 carbon atoms, and further preferably represents a branched alkyl group having 3 to 10 carbon atoms.

From the viewpoint of enhancement of exposure sensitivity of a resist upper layer film in EUV lithography, M in the above formula (B-1) more preferably represents Ti, Hf, Sn, or Bi, and further preferably represents Sn.

The amount of the metal source (B) in the composition for forming a metal-containing film is preferably 1 to 1,000 parts by mass, more preferably 5 to 900 parts by mass relative to 100 parts by mass of the silicon-containing polymer (A). When the amount of the metal source (B) is 1 part by mass or more, sufficient contribution to enhancement of the exposure sensitivity of the resist upper layer film can be achieved in EUV lithography. When the amount of the metal source (B) is 1,000 parts by mass or less, sufficient adhesiveness to a resist upper layer film pattern can be obtained, thereby controlling pattern collapse of the resist upper layer film. These can be adjusted as appropriate depending on the required properties when used in the composition for forming a metal-containing film.

### <(C) Organic Solvent>

The organic solvent (C) usable in the composition for forming a metal-containing film of the present invention is not particularly limited, as long as the silicon-containing polymer (A) and the metal source (B) as described above, as well as (D) a crosslinking agent, (E) an acid generator, (F) a surfactant, (G) a colorant, and other additives as described later (if contained) can be dissolved or dispersed therein.

Specifically, the organic solvent (C) is a monoalkyl ether of ethylene glycol, diethylene glycol, triethylene glycol, or the like, or a monoalkyl ether of propylene glycol, dipropylene glycol, or the like. Specifically, preferably used is propylene glycol monomethyl ether, ethylene glycol monomethyl ether, propylene glycol monoethyl ether, ethylene glycol monoethyl ether, propylene glycol monopropyl ether, ethylene glycol monopropyl ether, diacetone alcohol, 2-heptanone, cyclopentanone, cyclohexanone, γ-butyrolactone, or a mixture containing one or more thereof.

The blending amount of the organic solvent is preferably in the range of 200 to 10,000 parts, more preferably 250 to 5,000 parts relative to 100 parts by mass of the metal source (B).

### <(C') High-Boiling-Point Solvent>

In the composition for forming a metal-containing film of the present invention, the organic solvent (C) may contain (C') a high-boiling-point solvent.

The high-boiling-point solvent (C') can be one or more kinds of organic solvents having a boiling point of 180 degrees (°C) or higher.

For example, as the organic solvent (C), a mixture of one or more kinds of organic solvents having a boiling point of less than 180°C and one or more kinds of organic solvents having a boiling point of 180°C or higher (the high-boiling-point solvent (C')) may be used.

The high-boiling-point solvent (C') is not particularly limited to hydrocarbons, alcohols, ketones, esters, ethers, or chlorinated solvents as long as the respective components of the composition for forming a metal-containing film of the present invention can be dissolved or dispersed therein. Specific examples thereof include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, triethanolamine, and the like. These may be used alone or in mixture.

The high-boiling-point solvent (C') may appropriately be selected from, for example, those described above depending on the temperature for heat treatment of the composition for forming a resist underlayer film of the present invention, etc. The high-boiling-point solvent preferably has a boiling point of 180°C to 300°C, and further preferably has a boiling point of 200°C to 300°C. Since there is no risk of too quick volatilization during baking (heat treatment) at such boiling point, it is possible to prevent defects caused by dryness during film formation. Furthermore, since the solvent having such boiling point evaporates and does not remain in the film after baking, there is no risk of a bad influence on physical properties of the film such as etching resistance.

Furthermore, the blending amount of the high-boiling-point solvent (C') (if used) is preferably 1 to 30 parts by mass relative to 100 parts by mass of the organic solvent having a boiling point of less than 180°C. Such blending amount is preferred because it enables to impart sufficient thermal flowability during baking and the solvent does not remain in the film, causing no deterioration in physical properties of the film such as etching resistance.

### <Other Components>

The above composition for forming a metal-containing film may contain at least one or more of (D) a crosslinking agent, (E) an acid generator, (F) a surfactant, and (G) a colorant as necessary.

Hereinafter, components that can be contained in the composition for forming a metal-containing film of the present invention other than the resin (A), the metal source (B), and the organic solvent (C) as described above will be described.

### <(D) Crosslinking Agent>

Additionally, to the composition for forming a metal-containing film of the present invention, (D) a crosslinking agent can also be added in order to enhance a curing property and further prevent intermixing with a resist upper layer film.

The crosslinking agent is not particularly limited, and known crosslinking agents of various types can widely be used. One example thereof includes melamine crosslinking agents, glycoluril crosslinking agents, benzoguanamine crosslinking agents, urea crosslinking agents, β-hydroxyalkylamide crosslinking agents, isocyanurate crosslinking agents, aziridine crosslinking agents, oxazoline crosslinking agents, and epoxy crosslinking agents.

The above crosslinking agent (D) can be used alone or in combination of two or more kinds thereof. The addition amount of the crosslinking agent (if added) is preferably 5 to 100 parts, more preferably 10 to 50 parts relative to 100 parts of the above silicon-containing polymer (A). When the addition amount is 5 parts or more, the sufficient curing property can be exhibited, thereby preventing intermixing with a resist upper layer film. On the other hand, when the addition amount is 50 parts or less, there is no risk of deteriorated dry etching resistance due to the decreased proportion of the metal source (B) in the composition.

Specific examples of the melamine crosslinking agents include hexamethoxymethylated melamine, hexabutoxymethylated melamine, alkoxy- and/or hydroxy-substituted derivatives thereof, and partial self-condensates thereof.

Specific examples of the glycoluril crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea crosslinking agents include dimethoxymethylated dimethoxyethyleneurea, alkoxy- and/or hydroxy-substituted derivatives thereof, and partial self-condensates thereof.

Specific examples of the β-hydroxyalkylamide crosslinking agents include N,N,N',N'-tetra(2-hydroxyethyl)adipic acid amide.

Specific examples of the isocyanurate crosslinking agents include triglycidyl isocyanurate and triallyl isocyanurate.

Specific examples of the aziridine crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline crosslinking agents include 2,2'-isopropylidenebis(4-benzyl-2-oxazoline), 2,2'-isopropylidenebis(4-phenyl-2-oxazoline), 2,2'-methylenebis-4,5-diphenyl-2-oxazoline, 2,2'-methylenebis-4-phenyl-2-oxazoline, 2,2'-methylenebis-4-tertbutyl-2-oxazoline, 2,2'-bis(2-oxazoline), 1,3-phenylenebis(2-oxazoline), 1,4-phenylenebis(2-oxazoline), and 2-isopropenyloxazoline copolymer.

Specific examples of the epoxy crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Examples of the epoxy crosslinking agents and oxetane crosslinking agents are shown below, but not limited thereto.

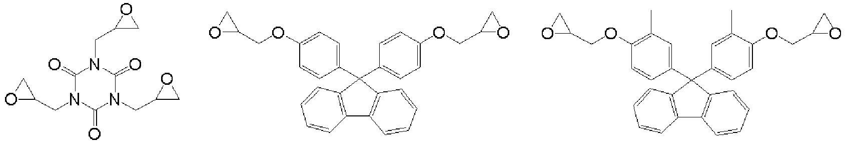

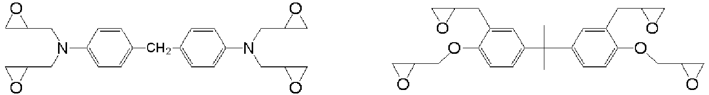

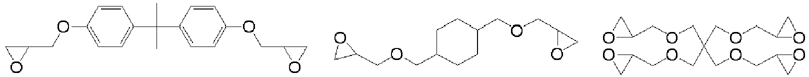

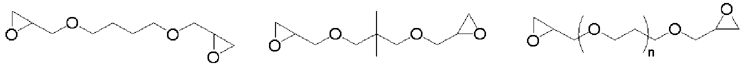

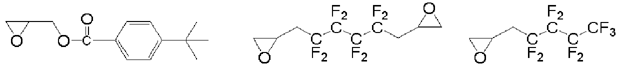

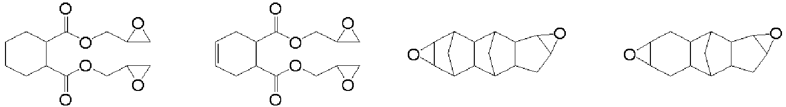

It is possible to purchase the above compounds, but it is also possible to obtain the epoxy crosslinking agents and the oxetane crosslinking agents by reacting a hydroxyl group with epibromohydrin or 3-bromomethyloxetane, etc. as in the following formula. In the following formula, R₅ represents a substituted or unsubstituted saturated monovalent organic group having 1 to 20 carbon atoms or unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms. Additionally, all the hydroxyl groups can be left unreacted. In this case, the total number of epoxy and oxetane is preferably greater than the number of hydroxyl groups, and more preferably, the total number of epoxy and oxetane is greater than two times the number of hydroxyl groups.

Furthermore, these compounds are contained in an amount of preferably 5 to 100 parts by mass, more preferably 10 to 50 parts by mass relative to 100 parts by mass of the metal source (B).

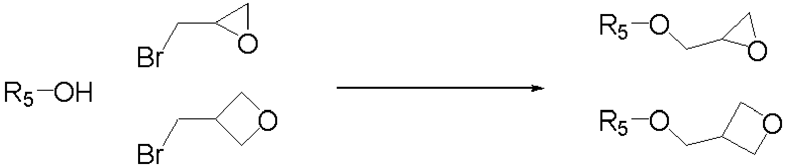

Specific examples of the compound having the hydroxyl group usable for the above reaction are shown below, but not limited thereto.

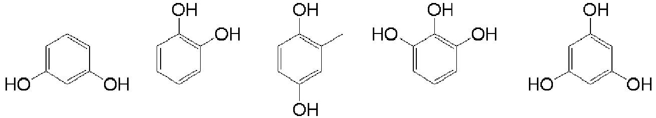

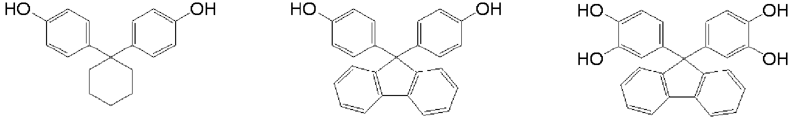

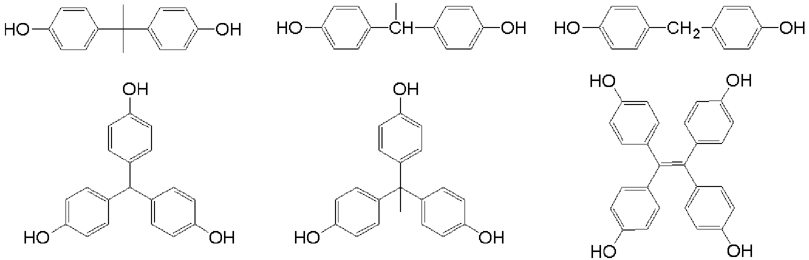

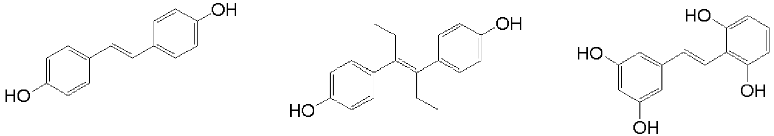

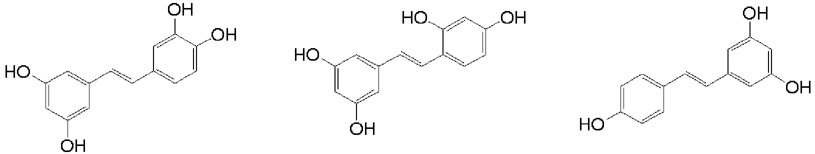

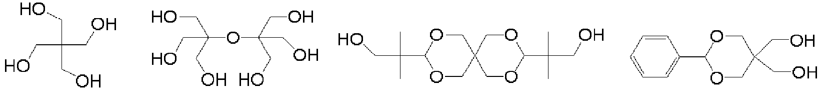

### <(E) Acid Generator>

One kind or two or more kinds of acid generators may further be blended with the composition for forming a metal-containing film of the present invention. As the acid generator, any substance acting as an acid precursor, such as a thermal acid generator, a photoacid generator, and an acid amplifier, may be used. In the present invention, the acid generator to be blended is more preferably a sulfonium salt, which is a photoacid generator and generates acid by action of high-energy ray. Specifically, materials described in paragraphs [0061] to [0085] of JP 2007-199653 A can be added, but the acid generator is not limited thereto.

The above acid generator can be used alone or in combination of two or more kinds thereof. The addition amount of the acid generator (if added) is preferably 0.05 to 50 parts by mass, more preferably 0.1 to 10 parts by mass relative to 100 parts by mass of the silicon-containing polymer (A).

### <(F) Surfactant>

Further in the present invention, a surfactant can be blended with the composition as necessary. Specifically, materials described in paragraph [0185] of JP 2009-126940 A can be added as such surfactant.

The desirable addition amount is preferably 0.01 to 5 parts by mass, more preferably 0.1 to 1 parts by mass relative to 100 parts by mass of the silicon-containing polymer (A).

### <(G) Colorant>

Further in the present invention, a colorant can be blended with the composition as necessary. Specifically, materials described in paragraph [0135] of JP 2023-180781 A can be added as such colorant.

### Other Components

### (Crosslinking Catalyst)

In the present invention, a crosslinking catalyst (Xc) may be blended with the composition for forming a metal-containing film. Examples of the crosslinking catalyst that can be blended include a compound represented by the following general formula (Xc0),

LₐH_{b}A (Xc0)

wherein L represents lithium, sodium, potassium, rubidium, cesium, sulfonium, iodonium, phosphonium, or ammonium; A represents a non-nucleophilic counter ion; "a" represents an integer of 1 or more, "b" represents 0 or an integer of 1 or more, and a+b represents a valence of the non-nucleophilic counter ion.

Specific examples of the crosslinking catalyst (Xc0) used in the present invention include a sulfonium salt of the following general formula (Xc-1), an iodonium salt of the following general formula (Xc-2), a phosphonium salt of the following general formula (Xc-3), an ammonium salt of the following general formula (Xc-4), an alkaline metal salt, etc., and a polysiloxane (Xc-10) having an ammonium salt, a sulfonium salt, a phosphonium salt, or an iodonium salt as a partial structure. Specifically, materials such as those described in paragraphs [0124] to [0163] of JP 2020-118960 A can be added. 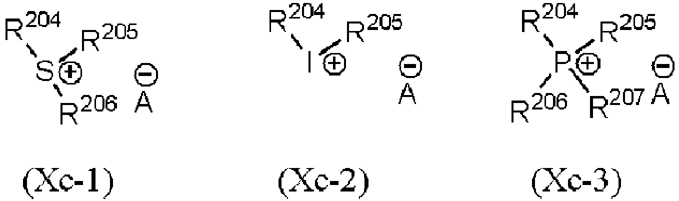 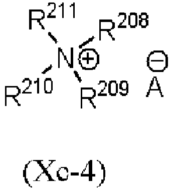 (In the formulae, each of R²⁰⁴, R²⁰⁵, R²⁰⁶, and R²⁰⁷ represents a linear, branched, or cyclic alkyl group, alkenyl group, oxoalkyl group, or oxoalkenyl group each having 1 to 12 carbon atoms, a substituted or unsubstituted aryl group having 6 to 20 carbon atoms, or an aralkyl group or aryloxoalkyl group having 7 to 12 carbon atoms, some or all of hydrogen atoms of these groups being optionally substituted with an alkoxy group or the like; additionally, R²⁰⁵ and R²⁰⁶ may form a ring, and when forming a ring, each of R²⁰⁵ and R²⁰⁶ represents an alkylene group having 1 to 6 carbon atoms; A⁻represents a non-nucleophilic counter ion; R²⁰⁸, R²⁰⁹, R²¹⁰, and R²¹¹ are the same as R²⁰⁴, R²⁰⁵, R²⁰⁶, and R²⁰⁷, but each may represent a hydrogen atom; R²⁰⁸ and R²⁰⁹, or R²⁰⁸, R²⁰⁹, and R²¹⁰ may form a ring, and when forming a ring, R²⁰⁸ and R²⁰⁹, or R²⁰⁸, R²⁰⁹, and R²¹⁰ represent an alkylene group having 3 to 10 carbon atoms.)

The above crosslinking catalysts (Xc-1), (Xc-2), (Xc-3), (Xc-4), and (Xc-10) can be used alone or in combination of two or more. The crosslinking catalyst is added in an amount of preferably 0.01 to 50 parts by mass, more preferably 0.1 to 40 parts by mass relative to 100 parts by mass of a base polymer (for example, the thermally crosslinkable polysiloxane (Sx) obtained by the above method).

Furthermore, raw materials described below can also be blended with the composition for forming a metal-containing film of the present invention.

### (Organic Acid)

To enhance stability of the silicon-containing polymer (A) in the present invention, it is preferable to add a monovalent, divalent, or polyvalent organic acid having 1 to 30 carbon atoms.

Examples of the acid to be added in this case include formic acid, acetic acid, propionic acid, butanoic acid, pentanoic acid, hexanoic acid, heptanoic acid, octanoic acid, nonanoic acid, decanoic acid, oleic acid, stearic acid, linoleic acid, linolenic acid, benzoic acid, phthalic acid, isophthalic acid, terephthalic acid, salicylic acid, trifluoroacetic acid, monochloroacetic acid, dichloroacetic acid, trichloroacetic acid, oxalic acid, malonic acid, methylmalonic acid, ethylmalonic acid, propylmalonic acid, butylmalonic acid, dimethylmalonic acid, diethylmalonic acid, succinic acid, methylsuccinic acid, glutaric acid, adipic acid, itaconic acid, maleic acid, fumaric acid, citraconic acid, citric acid, and the like. Particularly, oxalic acid, maleic acid, formic acid, acetic acid, propionic acid, citric acid, and the like are preferable. Furthermore, a mixture of two or more acids may be used to keep the stability.

The organic acid is added in an amount of 0.001 to 25 parts by mass, preferably 0.01 to 15 parts by mass, and more preferably 0.1 to 5 parts by mass, relative to 100 parts by mass of the silicon-containing polymer (A) contained in the composition for forming a metal-containing film of the present invention.

Alternatively, the above organic acid may be blended based on the pH of the composition for forming a metal-containing film of the present invention so as to satisfy preferably 0≤pH≤7, more preferably 0.3≤pH≤6.5, and further preferably 0.5≤pH≤6.

### (Water)

In the present invention, water may be added to the composition. When the polysiloxane (Sx) is used in the silicon-containing polymer (A) contained in the composition for forming a metal-containing film of the present invention, the polysiloxane (Sx) compound is hydrated by adding water, resulting in enhanced lithography performance. The water content of the solvent component of the composition for forming a metal-containing film of the present invention is more than 0% by mass and less than 50% by mass, particularly preferably 0.3 to 30% by mass, and further preferably 0.5 to 20% by mass. When the addition amount of the water falls within the above range, the metal-containing film has favorable film thickness uniformity, and there is no risk of occurrence of repelling or decreased lithography performance.

All the solvents including water are suitably used in a total amount of 100 to 100,000 parts by mass, particularly 200 to 50,000 parts by mass, relative to 100 parts by mass of the silicon-containing polymer (Sx) as a base polymer.

### (Stabilizer)

Further in the present invention, a stabilizer can be added to the composition. As the stabilizer, monohydric, dihydric, or polyhydric alcohol containing a cyclic ether as a substituent can be added. Particularly, by adding any stabilizer described in paragraphs [0181] to [0182] of JP 2009-126940 A, it is possible to enhance the stability of the composition for forming a metal-containing film.

### <Method for Forming Metal-Containing Film>

The present invention provides a method for forming a filling film using the above-described composition for forming a metal-containing film, the filling film functioning as a resist underlayer film or middle layer film of a multilayer resist film used for lithography.

In a method for forming a metal-containing film using the composition for forming a metal-containing film of the present invention, the above-described composition for forming a metal-containing film is coated on a substrate to be processed by a spin coat method or the like. The use of the spin coat method or the like can provide a favorable planarization property. After the spin coating, baking (heat treatment) is performed to evaporate the solvent and facilitate a crosslinking reaction to prevent mixing with a resist upper layer film. The baking is preferably performed at 100°C or higher and 600°C or lower for 10 to 600 seconds, more preferably performed at 200°C or higher and 500°C or lower for 10 to 300 seconds. Considering effects on device damage and deformation of a wafer, the upper limit of the heating temperature in a wafer process of lithography is preferably 600°C or lower and more preferably 500°C or lower.

Furthermore, in the method for forming a metal-containing film using the composition for forming a metal-containing film of the present invention, a metal-containing film can also be formed by coating the composition for forming a metal-containing film of the present invention on a substrate to be processed by a spin coat method or the like in the same manner as described above, and baking and curing the composition for forming a metal-containing film in an atmosphere with an oxygen concentration of 0.1% by volume or more and 21% by volume or less.

By baking the composition for forming a metal-containing film of the present invention in such oxygen atmosphere, it is possible to obtain a sufficiently cured film. While the atmosphere during the baking may be air, filling an inert gas such as N₂, Ar, or He to reduce the amount of oxygen is preferable to prevent oxidation of the metal-containing film. To prevent oxidation, it is necessary to control the oxygen concentration, which is preferably 1000 ppm or less and more preferably 100 ppm or less (volume basis). It is preferable to prevent oxidation of the metal-containing film during the baking so as not to cause increased absorption or reduced etching resistance.

### <Patterning Process>

As a patterning process with a two-layer resist process using the above composition for forming a metal-containing film, the present invention also provides a patterning process, including steps of:
(I-1) applying the composition for forming a metal-containing film of the present invention on a substrate to be processed and thereafter performing heat treatment to form a metal-containing film;
(I-2) forming a resist upper layer film on the metal-containing film using a photoresist material;
(I-3) forming a pattern in the resist upper layer film by developing the resist upper layer film using a developer after pattern exposure;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

Since the resist upper layer film in the above two-layer resist process has etching resistance to a fluorine gas or a chlorine gas, the dry etching of the metal-containing film while using the resist upper layer film as a mask is preferably performed by using an etching gas mainly composed of a fluorine gas or a chlorine gas in the two-layer resist process.

As a patterning process with a three-layer resist process using the above composition for forming a metal-containing film of the present invention, the present invention also provides a patterning process, including steps of:
(II-1) forming an organic resist underlayer film on a substrate to be processed;
(II-2) applying the composition for forming a metal-containing film of the present invention on the organic resist underlayer film and thereafter performing heat treatment to form a metal-containing film;
(II-3) forming a resist upper layer film on the metal-containing film using a photoresist material;
(II-4) forming a pattern in the resist upper layer film by developing the resist upper layer film using a developer after pattern exposure;
(II-5) transferring the pattern to the metal-containing film by dry etching while using the resist upper layer film having the formed pattern as a mask;
(II-6) transferring the pattern to the organic resist underlayer film by dry etching while using the metal-containing film having the transferred pattern as a mask; and
(II-7) processing the substrate to be processed while using the organic resist underlayer film having the formed pattern as a mask to form the pattern in the substrate to be processed.

Since a resist middle layer film (metal-containing film) in the above three-layer resist process has etching resistance to an oxygen gas, the dry etching of the organic resist underlayer film while using the resist middle layer film as a mask is preferably performed by using an etching gas mainly composed of an oxygen gas in the three-layer resist process.

Since the organic resist underlayer film in the above three-layer resist process has etching resistance to a fluorine gas, the dry etching of the substrate to be processed while using the organic resist underlayer film as a mask is preferably performed by using an etching gas mainly composed of a fluorine gas in the three-layer resist process.

The inventive patterning process with the three-layer resist process will be described with reference to FIG. 1. Firstly, an organic resist underlayer film 2 is formed on a substrate to be processed 1 (I-A). Thereafter, a metal-containing film 3 is formed as a resist middle layer film using the composition for forming a metal-containing film of the present invention (I-B), and a resist upper layer film 4 is formed thereon using a photoresist material (I-C). Next, exposure P of the resist upper layer film 4 is performed by using a mask 5 (I-D), and PEB (post exposure bake) is performed (I-E). Next, development is performed to form a resist upper layer film pattern 4a (I-F). Next, the metal-containing film 3 is processed by dry etching while using the resist upper layer film pattern 4a as a mask, thereby forming a metal-containing film pattern 3a (I-G). Next, the resist upper layer film pattern 4a is removed and thereafter the organic resist underlayer film 2 is subjected to dry etching by using the metal-containing film pattern 3a as a mask, thereby forming an organic resist underlayer film pattern 2a (I-H). Further, the metal-containing film pattern 3a is removed and thereafter the substrate to be processed 1 is etched by using the organic resist underlayer film pattern 2a as a mask, thereby forming a pattern 1a (I-I).

In the above patterning process, the resist upper layer film may be either a positive or negative type, and the same one as a typically used photoresist composition can be used therefor. Additionally, the photoresist composition may contain a metal atom such as Sn, In, Ga, Ge, Al, Ce, La, Cs, Zr, Hf, Ti, Bi, Sb, and Zn. In a case of forming the resist upper layer film with the above photoresist composition, a spin coat method or a method using deposition processing by CVD or ALD may be applied.

When the photoresist composition is formed by the spin coat method, prebaking is performed after resist application, preferably at 60 to 180°C for 10 to 300 seconds. Thereafter, exposure is performed according to a usual manner, followed by post exposure bake (PEB) and development, thereby obtaining a resist pattern. Note that the thickness of the resist upper layer film is not particularly limited, but preferably 10 to 500 nm and particularly preferably 20 to 400 nm.

Examples of exposure light include high-energy ray having a wavelength of 300 nm or less; specifically, excimer laser of 248 nm, 193 nm, or 157 nm, soft X-ray of 3 to 20 nm, electron beam, X-ray, and the like.

As the above patterning process for the resist upper layer film, photolithography with a wavelength of 5 nm or more and 300 nm or less, direct drawing using an electron beam, nanoimprinting, or a combination thereof can be used to form a pattern. However, EUV light is the most preferable in the present invention. That is, the pattern exposure is preferably performed using EUV light in the step (I-3), or the pattern exposure is preferably performed using EUV light in the step (II-4).

Additionally, a development method in the patterning process is preferably alkaline development or development using an organic solvent.

Next, etching is performed by using the obtained resist pattern as a mask. The etching of the silicon-containing resist middle layer film (metal-containing film) in the three-layer resist process is performed using a chlorofluorocarbon gas while using the upper layer resist pattern as a mask. As a result, a silicon-containing resist middle layer film (metal-containing film) pattern is formed.

Next, the organic resist underlayer film is etched by using the obtained silicon-containing resist middle layer film (metal-containing film) pattern as a mask. The etching processing of the organic resist underlayer film is preferably performed by using an etching gas mainly composed of an oxygen gas.

The subsequent etching of the workpiece can also be performed in a usual manner. For example, if the workpiece is a SiO₂, SiN, or silica low-dielectric insulating film, etching is performed mainly using a chlorofluorocarbon gas. When the substrate is processed by etching with a chlorofluorocarbon gas, the silicon-containing resist middle layer film (metal-containing film) pattern in the three-layer resist process is debonded simultaneously with the processing of the substrate.

The silicon-containing film (metal-containing film) obtained from the composition for forming a metal-containing film of the present invention is characterized by excellent etching resistance upon such etching of the workpiece.

Note that the workpiece (substrate to be processed) is not particularly limited, and a substrate made of Si, α-Si, p-Si, SiO₂, SiN, SiON, W, TiN, Al, or the like, the substrate on which a layer to be processed is deposited, etc. are used. As the layer to be processed, various Low-k films such as those made of Si, SiO₂, SiON, SiN, p-Si, α-Si, W, W-Si, Al, Cu, Al-Si, or the like, and a stopper film thereof are used, which can be formed to have a thickness of typically 50 to 10,000 nm and particularly 100 to 5,000 nm. Note that in the case of depositing the layer to be processed, the substrate and the layer to be processed for use are made of different materials.

Examples of the organic resist underlayer film material usable for the above organic resist underlayer film include already known underlayer films for a three-layer resist method or a two-layer resist method using a silicon resist composition, 4,4'-(9-fluorenylidene)bisphenol novolak resin (molecular weight: 11,000) described in JP 2005-128509 A, and a number of resins including novolak resins, which are known as resist underlayer film materials for the two-layer resist method or the three-layer resist method. Furthermore, when higher heat resistance than that of a typical novolak resin is desired, a polycyclic skeleton can be introduced, as in a 6,6'-(9-fluorenylidene)-di(2-naphthol) novolak resin, or a polyimide resin can also be selected (for example, JP 2004-153125 A).

The above organic resist underlayer film can be formed on the substrate to be processed by the spin coat method or the like using a composition solution, as with the photoresist composition. After forming the organic resist underlayer film by the spin coat method or the like, baking is preferably performed to evaporate the organic solvent. Preferably, a baking temperature is within a range of 80 to 400°C and baking time is within a range of 10 to 300 seconds.

Instead of the above organic resist underlayer film material, it is also possible to apply an organic hard mask formed by a CVD or ALD method.

### EXAMPLE

Hereinafter, the present invention will be specifically described with reference to Synthesis Examples, Examples, and Comparative Examples. However, the present invention is not limited by the description thereof. Incidentally, in the examples below, % represents % by mass, and the molecular weight Mw represents a weight average molecular weight in terms of polystyrene measured by GPC.

### <Preparation of Polysiloxane Compound>

### Synthesis Example 1

To a mixture of 120 g of methanol, 0.1 g of 10% nitric acid, and 60 g of deionized water, a mixture of 30.6 g of a compound (101), 38.1 g of a compound (102), and 5.9 g of a compound (110) was added and maintained at 40°C for 12 hours to perform hydrolysis condensation. After completion of the reaction, 600 g of propylene glycol ethyl ether (PGEE) was added thereto, and water used for the hydrolysis condensation and an alcohol by-product were distilled off under reduced pressure, thereby obtaining 440 g of a PGEE solution of a polysiloxane compound 1 (compound concentration: 10%). The molecular weight of the polysiloxane compound 1 in terms of polystyrene was measured and found Mw=2,900.

### Synthesis Examples 2 to 8

Monomers shown in Table 1 were used to perform [Synthesis Example 2] to [Synthesis Example 8] under the same conditions as in Synthesis Example 1, thereby obtaining respective target products.

**[Table 1]**

| Synthesis Example | Reaction Raw Materials | Mw |
|---|---|---|
| 1 | Compound (101): 30.6 g, Compound (102): 38.1 g, Compound (110): 5.9 g | 2900 |
| 2 | Compound (101): 30.6 g, Compound (102): 38.1 g, Compound (111): 6.4 g | 2300 |
| 3 | Compound (101): 30.6 g, Compound (102): 38.1 g, Compound (112): 7.0 g | 2900 |
| 4 | Compound (101): 30.6 g, Compound (102): 38.1 g, Compound (113): 6.8 g | 2300 |
| 5 | Compound (101): 30.6 g, Compound (102): 38.1 g, Compound (114): 7.1 g | 2500 |
| 6 | Compound (101): 30.6 g, Compound (102): 38.1 g, Compound (115): 8.9 g | 2600 |
| 7 | Compound (101): 30.6 g, Compound (102): 38.1 g, Compound (116): 8.0 g | 2300 |
| 8 | Compound (100): 5.0 g, Compound (101): 30.6 g, Compound (102): 38.1 g | 2500 |

The compounds used in Examples and Comparative Examples are shown below.
PhSi(OCH₃)₃...Compound (100)
CH₃Si(OCH₃)₃...Compound (101)
Si(OCH₃)₄...Compound (102)

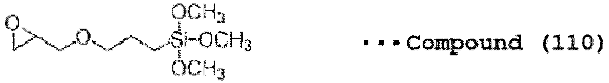

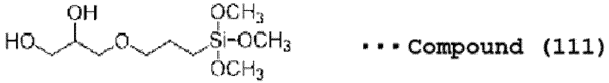

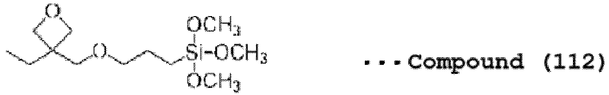

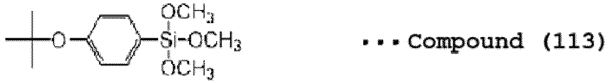

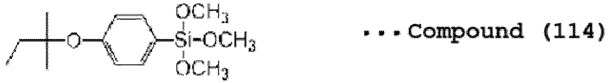

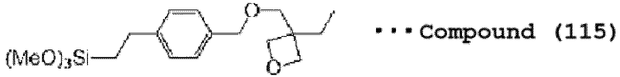

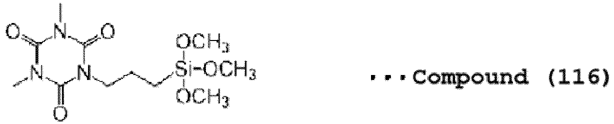

### Synthesis Example 9

1400 g of ethanol, 700 g of ultrapure water, and 50 g of 25% tetramethylammonium hydroxide were added to prepare a homogeneous solution under a nitrogen atmosphere at 40°C. A mixture of 138.6 g of 2-(3,4-epoxycyclohexyl)ethyltrimethoxysilane and 37.2 g of phenyltrimethoxysilane was slowly added dropwise, and thereafter the reaction was allowed to proceed at 40°C for 2 hours. After completion of the reaction, 35 g of acetic acid was added to stop the reaction, and the ethanol was distilled off under reduced pressure. To the solution after the distillation, 2000 ml of ethyl acetate was added, and the aqueous layer was separated. The organic layer was washed twice with 400 ml of ultrapure water, 1000 g of PGMEA (propylene glycol monomethyl ether acetate) was then added, and water and the low-boiling-point solvent were distilled off, thereby collecting 600 g of a PGMEA solution of a polysiloxane compound 9 (compound concentration: 20%). The molecular weight of the polysiloxane compound 9 in terms of polystyrene was measured and found Mw=2,800.

### <Preparation of Polycarbosilane>

### Synthesis Example 10

Into a reaction vessel filled with nitrogen, 2.9 g of magnesium and 5.5 g of tetrahydrofuran were added and stirred at 20°C. Next, 8.7 g of a compound represented by the following formula (Z-1), 2.2 g of a compound represented by the following formula (Z-2), and 4.7 g of a compound represented by the following formula (Z-3) were dissolved in 56 g of tetrahydrofuran to prepare a monomer solution. The internal temperature of the reaction vessel was adjusted to 20°C, and the above monomer solution was added dropwise thereto over 1 hour while being stirred. The time at which the dropwise addition was completed was defined as a start time of the reaction, and the reaction was allowed to proceed at 40°C for 1 hour and thereafter at 60°C for 3 hours. After completion of the reaction, 33 g of tetrahydrofuran was added, and the polymerization solution was ice-cooled to 10°C or lower. 15.2 g of triethylamine was added to the cooled polymerization solution, and then 4.8 g of methanol was added dropwise from a dropping funnel over 10 minutes while being stirred. The time at which the dropwise addition was completed was defined as a start time of the reaction, and the reaction was allowed to proceed at 20°C for 1 hour. The polymerization solution was charged into 110 g of diisopropyl ether, and a precipitated salt was filtered out. Next, tetrahydrofuran, excess triethylamine, and excess methanol in the filtrate were removed using an evaporator. A resulting residue was charged into 28 g of diisopropyl ether, a precipitated salt was filtered out, and 20 g of cyclohexanone was added to the filtrate. The diisopropyl ether in the solution was removed using an evaporator, thereby obtaining a cyclohexanone solution of a polycarbosilane compound 10 having a solid content concentration of 8% by mass. The polycarbosilane compound 10 had Mw of 1,960.

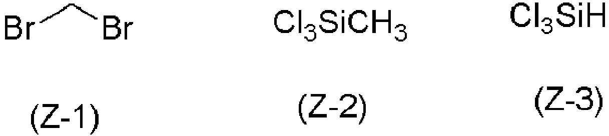

### <Preparation of Polysilane Compound>

### Synthesis Example 11

10.0 g of OGSOL SI-10-20 (Mw 1,900) produced by Osaka Gas Chemicals Co., Ltd. was dissolved in 100.0 g of tetrahydrofuran, and 6.0 g of triethylamine and 16.0 g of ultrapure water were added thereto. This solution was allowed to react for 7 hours under refluxing. Thereafter, 375 g of propylene glycol monoethyl ether (PGEE) was added thereto, and the solution was concentrated under reduced pressure, thereby obtaining 91.3 g of a PGEE solution of a polysilane compound 11 (polymer concentration: 11%). Mw was 980.

### Synthesis Example 12

10.0 g of OGSOL SI-20-10 (Mw 1,300) produced by Osaka Gas Chemicals Co., Ltd. was dissolved in 100.0 g of tetrahydrofuran, and 2.0 g of 29% ammonia water and 6.0 g of ultrapure water were added thereto. This solution was allowed to react for 6.5 hours under refluxing. Thereafter, 250 g of propylene glycol monoethyl ether (PGEE) was added thereto, and the solution was concentrated under reduced pressure, thereby obtaining 70.3 g of a PGEE solution of a polysilane compound 12 (polymer concentration: 15%). Mw was 870.

### Synthesis Example 13

10.0 g of OGSOL SI-20-10 (improved) (Mw 1,400) produced by Osaka Gas Chemicals Co., Ltd. was dissolved in 100.0 g of tetrahydrofuran, and 6.0 g of triethylamine and 16.0 g of ultrapure water were added thereto. This solution was allowed to react for 12 hours under refluxing. Thereafter, 250 g of propylene glycol monoethyl ether (PGEE) was added thereto, and the solution was concentrated under reduced pressure, thereby obtaining 71.3 g of a PGEE solution of a polysilane compound 133 (polymer concentration: 14%). Mw was 830.

The blending amounts in Synthesis Examples 11 to 13 are together shown in Table 2 below.

**[Table 2]**

| Synthesis Example | Reaction Raw Material | Mw |
|---|---|---|
| 11 | SI-10-20: 10.0 g | 980 |
| 12 | SI-20-10: 10.0 g | 870 |
| 13 | SI-20-10 improved: 10.0 g | 830 |

### Synthesis Example 14

To a mixture of 120 g of PGEE, 1 g of 70% nitric acid, and 60 g of deionized water, a mixture of 17.0 g of methyltrimethoxysilane (101), 5.0 g of phenyltrimethoxysilane (100), 45.7 g of tetramethoxysilane (102), and 54.6 of the PGEE solution of the polysilane compound 11 was added and maintained at 40°C for 12 hours to perform hydrolysis condensation. After completion of the reaction, 300 g of PGEE was added, and an alcohol by-product and excess water were distilled off under reduced pressure, thereby obtaining 300 g of a PGEE solution of a polysilane compound 14 (polymer concentration: 120). Mw was 3,000.

### Synthesis Example 15

To a mixture of 80 g of PGEE, 1 g of 70% nitric acid, and 60 g of deionized water, a mixture of 17.0 g of methyltrimethoxysilane (101), 5.0 g of phenyltrimethoxysilane (100), 45.7 g of tetramethoxysilane (102), and 43.6 of the PGEE solution of the polysilane compound 13 was added and maintained at 40°C for 12 hours to perform hydrolysis condensation. After completion of the reaction, 300 g of PGEE was added, and an alcohol by-product and excess water were distilled off under reduced pressure, thereby obtaining 320 g of a PGEE solution of a polysilane compound 15 (polymer concentration: 11%). Mw was 2,900.

The blending amounts in Synthesis Examples 14 to 15 are together shown in Tabel 3 below.

**[Table 3]**

| Synthesis Example | Reaction Raw Material | | Mw |
|---|---|---|---|
| | Silicon Compound | Polysilane Compound | |
| 14 | 101: 17.0 g, 100: 5.0 g, | 11: 54.6 g | 3000 |
| | 102: 45.7 g, | | |
| 15 | 101: 17.0 g, 100: 5.0 g, | 13: 43.6 g | 2900 |
| | 102: 45.7 g, | | |

### Examples and Comparative Examples

The polysiloxane compounds 1 to 9, the polycarbosilane compound 10, and the polysilane compounds 11 to 15 obtained in the above Synthesis Examples, metal sources represented by the following general formulae (M-1 to 17), crosslinking agents (XL-1 to 2), crosslinking catalysts, acid generators (PAG-1 to 4), and solvents were mixed in the proportions shown in Tables 5-1 to 5-2, and filtered through a 0.1 um filter made of a fluororesin, thereby respectively preparing the composition solutions for forming a metal-containing film. The composition solutions are respectively denoted as UDL-1 to 49 and Comparative Examples UDL-1 to 3.

### Metal Salts (M-1) to (M-17)

The following metal compounds were used as the metal salts.
(M-1): titanium(IV) 2-ethylhexanoate
(M-2): tris(2,2,6,6-tetramethyl-3,5-heptanedionato)chromium(III)
(M-3): tris(2,2,6,6-tetramethyl-3,5-heptanedionato)manganese(III)
(M-4): tris(2,2,6,6-tetramethyl-3,5-heptanedionato)iron(III)
(M-5): cobalt(II) 2-ethylhexanoate
(M-6): nickel(II) bis(hexafluoroacetylacetonate)
(M-7): copper(I) 2-ethylhexanoate
(M-8): zinc(II) 4-vinyl benzoate
(M-9): tetra(2,2,6,6-tetramethyl-3,5-heptanedionato)zirconium(IV)
(M-10): molybdenum(IV) 2-ethylhexanoate
(M-11): indium(III) ethylbutyrate
(M-12): tin(II) acetate
(M-13): tin(II) 2-ethylhexanoate
(M-14): tin(II) acetylacetonate
(M-15): tin(II) 4-fluorobenzeneacetate
(M-16): hafnium(IV) carboxyethyl acrylate
(M-17): bismuth(III) 2-ethylhexanoate

### Crosslinking Agents (XL-1 to XL-2)

The crosslinking agents (XL-1) to (XL-2) used in the composition for forming a metal-containing film are shown below.

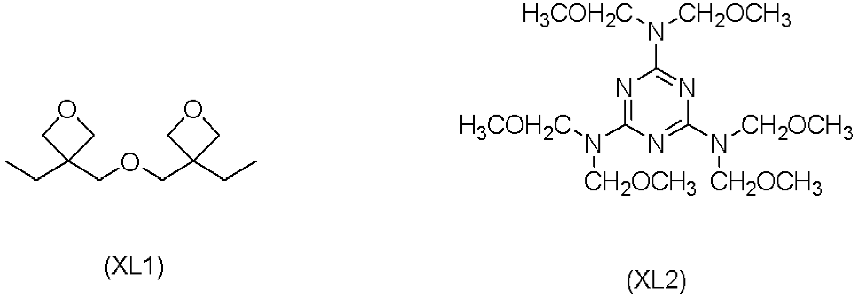

The following crosslinking catalysts were used.
XLC-1...triphenylsulfonium nitrate
XLC-2...mono(triphenylsulfonium)maleate
XLC-3...triethylphenylammonium iodide

The following solvents were used.
PGEE... propylene glycol ethyl ether
PGMEA...propylene glycol methyl ether acetate

The photoacid generators in Table 4 below were used.

**[Table 4]**

| **Acid Generator** | **Structure** | **Acid Genera**tor | **structure** |
|---|---|---|---|
| 1 | 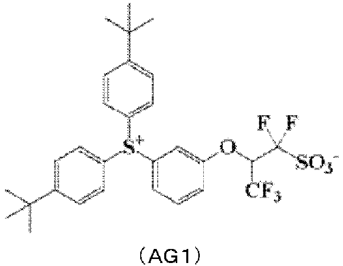 | 2 | 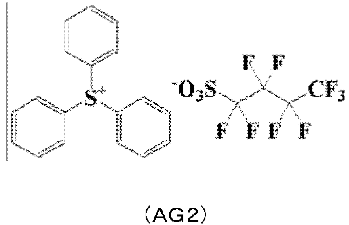 |
| 3 | 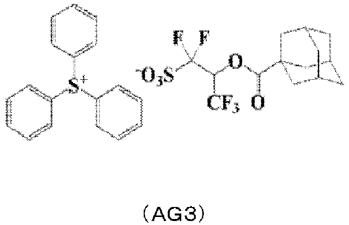 | 4 | 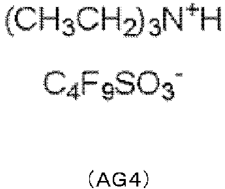 |

As the high-boiling-point solvent (C-1), ethylene glycol dibenzyl ether having a boiling point of 364°C was used.

As the metal source (R-1) for Comparative Example, ZrO₂ nanoparticles were used (average primary particle diameter: 5 nm, 915505, Sigma-Aldrich Corp).

**[Table 5-1]**

| Composition for forming metal-containing film | Silicon-containing polymer | Metal source | Additive | Solvent |
|---|---|---|---|---|
| | (parts by mass) | (parts by mass) | (parts by mass) | (parts by mass) |
| UDL-1 | Compound 1(1) | M-13(0.2) | None | PGEE(100) |
| UDL-2 | Compound 2(1) | M-13(0.2) | None | PGEE(100) |
| UDL-3 | Compound 3(1) | M-13(0.2) | None | PGEE(100) |
| UDL-4 | Compound 4(1) | M-13(0.2) | None | PGEE(100) |
| UDL-5 | Compound 5(1) | M-13(0.2) | None | PGEE(100) |
| UDL-6 | Compound 6(1) | M-13(0.2) | None | PGEE(100) |
| UDL-7 | Compound 7(1) | M-13(0.2) | None | PGEE(100) |
| UDL-8 | Compound 8(1) | M-13(0.2) | None | PGEE(100) |
| UDL-9 | Compound 10(1) | M-13(0.2) | None | PGEE(100) |
| UDL-10 | Compound 11(1) | M-13(0.2) | None | PGEE(100) |
| UDL-11 | Compound 12(1) | M-13(0.2) | None | PGEE(100) |
| UDL-12 | Compound 13(1) | M-13(0.2) | XLC-1 (0. 1) | PGEE(100) |
| UDL-13 | Compound 14(1) | M-13(0.2) | None | PGEE(100) |
| UDL-14 | Compound 15(1) | M-13(0.2) | XLC-2(0.1) | PGEE(100) |
| UDL-15 | Compound 1(1) | M-13(0.2) | C-1(5) | PGEE(100) |
| UDL-16 | Compound 2(1) | M-13(0.2) | XL-1(0.5) | PGEE(100) |
| UDL-17 | Compound 3(1) | M-13(0.2) | XLC-1 (0. 1) | PGEE(100) |
| UDL-18 | Compound 4(1) | M-13(0.2) | XLC-2(0.1) | PGEE(100) |
| UDL-19 | Compound 5(1) | M-13(0.2) | XLC-3(0.1) | PGEE(100) |
| UDL-20 | Compound 6(1) | M-13(0.2) | AG1(0.1) | PGEE(100) |
| UDL-21 | Compound 7(1) | M-13(0.2) | AG2(0.1) | PGEE(100) |
| UDL-22 | Compound 8(1) | M-13(0.2) | AG3(0.1) | PGEE(100) |
| UDL-23 | Compound 9(1) | M-1 (0. 2) | None | PGMEA(100) |
| UDL-24 | Compound 9(1) | M-2(0.2) | None | PGMEA(100) |
| UDL-25 | Compound 9(1) | M-3(0.2) | None | PGMEA(100) |
| UDL-26 | Compound 9(1) | M-4(0.2) | None | PGMEA(100) |

**[Table 5-2]**

| Composition for forming metal-containing film | Silicon-containing polymer | Metal source | Additive | Solvent |
|---|---|---|---|---|
| | (parts by mass) | (parts by mass) | (parts by mass) | (parts by mass) |
| UDL-27 | Compound 9(1) | M-5(0.2) | None | PGMEA(100) |
| UDL-28 | Compound 9(1) | M-6(0.2) | None | PGMEA(100) |
| UDL-29 | Compound 9(1) | M-7(0.2) | None | PGMEA(100) |
| UDL-30 | Compound 9(1) | M-Θ(0.2) | None | PGMEA(100) |
| UDL-31 | Compound 9(1) | M-9(0.2) | None | PGMEA(100) |
| UDL-32 | Compound 9(1) | M-10(0.2) | None | PGMEA(100) |
| UDL-33 | Compound 9(1) | M-11(0.2) | None | PGMEA(100) |
| UDL-34 | Compound 9(1) | M-12(0.2) | None | PGMEA(100) |
| UDL-35 | Compound 9(1) | M-13(0.2) | None | PGEE(100) |
| UDL-36 | Compound 9(1) | M-14(0.2) | None | PGMEA(100) |
| UDL-37 | Compound 9(1) | M-15(0.2) | None | PGMEA(100) |
| UDL-38 | Compound 9(1) | M-16(0.2) | None | PGMEA(100) |
| UDL-39 | Compound 9(1) | M-17(0.2) | None | PGMEA(100) |
| UDL-40 | Compound 9(1) | M-13(0.2) | C-1(5) | PGMEA(100) |
| UDL-41 | Compound 9(1) | M-13(0.5) | XL-1(0.5) | PGMEA(100) |
| UDL-42 | Compound 9(1) | M-13(0.05) | XL-2(0.5) | PGMEA(100) |
| UDL-43 | Compound 9(1) | M-1 (0. 2) | XLC-1 (0. 1) | PGMEA(100) |
| UDL-44 | Compound 9(1) | M-5(0.2) | XLC-2(0.1) | PGMEA(100) |
| UDL-45 | Compound 9(1) | M-7(0.2) | XLC-3(0.1) | PGMEA(100) |
| UDL-46 | Compound 9(1) | M-10(0.2) | AG1(0.1) | PGMEA(100) |
| UDL-47 | Compound 9(1) | M-13(0.2) | AG2(0.1) | PGMEA(100) |
| UDL-48 | Compound 9(1) | M-17(0.2) | AG3(0.1) | PGMEA(100) |
| UDL-49 | Compound 9(1) | M-13(0.2) | AG4(0.1) | PGMEA(100) |
| Comp. Ex. UDL-1 | Compound 9(1) | - | - | PGMEA(100) |
| Comp. Ex. UDL-2 | - | M-13(1) | - | PGMEA(100) |
| Comp. Ex. UDL-3 | Compound 9(1) | R-1(0.2) | - | PGMEA(100) |

### Examples 1-1 to 1-49, Comparative Examples 1-1 to 1-3: Etching Resistance

The composition for forming a metal-containing film (UDL-1 to 49 and Comparative Example UDL-1 to 3) was applied onto a silicon substrate and heated at 220°C for 60 seconds using a hot plate, thereby forming a metal-containing film having a film thickness of 10 nm. Film thickness A was measured. Next, etching with O₂ gas was performed for 20 seconds under the following conditions using a dry etching system TE-8500 produced by Tokyo Electron Limited, and film thickness B was measured. Film thickness etched in 20 seconds (film thickness B - film thickness A) was calculated as etching resistance.

In the etching using O₂ gas, when difference between the film thickness B and A was less than 5 nm, it was evaluated as "A" (very good). When the difference was 5 nm or more and less than 15 nm, it was evaluated as "B" (good). When the difference was 15 nm or more, it was evaluated as "C" (poor). The results are shown in Tables 6-1 to 6-2.

O₂ gas etching conditions are as described below.
Chamber pressure: 500 mT
RF power: 100 W
O₂ gas flow rate: 30 sccm
N₂ gas flow rate: 270 sscm
Time: 20 sec

**[Table 6-1]**

| Example | Composition for forming metal-containing film | Etching resistance |
|---|---|---|
| | | O2 |
| Example 1-1 | UDL-1 | A |
| Example 1-2 | UDL-2 | A |
| Example 1-3 | UDL-3 | A |
| Example 1-4 | UDL-4 | A |
| Example 1-5 | UDL-5 | A |
| Example 1-6 | UDL-6 | A |
| Example 1-7 | UDL-7 | A |
| Example 1-8 | UDL-8 | A |
| Example 1-9 | UDL-9 | A |
| Example 1-10 | UDL-10 | A |
| Example 1-11 | UDL-11 | A |
| Example 1-12 | UDL-12 | A |
| Example 1-13 | UDL-13 | A |
| Example 1-14 | UDL-14 | A |
| Example 1-15 | UDL-15 | A |
| Example 1-16 | UDL-16 | A |
| Example 1-17 | UDL-17 | A |
| Example 1-18 | UDL-18 | A |
| Example 1-19 | UDL-19 | A |
| Example 1-20 | UDL-20 | A |
| Example 1-21 | UDL-21 | A |
| Example 1-22 | UDL-22 | A |
| Example 1-23 | UDL-23 | A |
| Example 1-24 | UDL-24 | A |
| Example 1-25 | UDL-25 | A |
| Example 1-26 | UDL-26 | A |

**[Table 6-2]**

| Example | Composition for forming metal-containing film | Etching resistance |
|---|---|---|
| | | O2 |
| Example 1-27 | UDL-27 | A |
| Example 1-28 | UDL-28 | A |
| Example 1-29 | UDL-29 | A |
| Example 1-30 | UDL-30 | A |
| Example 1-31 | UDL-31 | A |
| Example 1-32 | UDL-32 | A |
| Example 1-33 | UDL-33 | A |
| Example 1-34 | UDL-34 | A |
| Example 1-35 | UDL-35 | A |
| Example 1-36 | UDL-36 | A |
| Example 1-37 | UDL-37 | A |
| Example 1-38 | UDL-38 | A |
| Example 1-39 | UDL-39 | A |
| Example 1-40 | UDL-40 | A |
| Example 1-41 | UDL-41 | A |
| Example 1-42 | UDL-42 | A |
| Example 1-43 | UDL-43 | A |
| Example 1-44 | UDL-44 | A |
| Example 1-45 | UDL-45 | A |
| Example 1-46 | UDL-46 | A |
| Example 1-47 | UDL-47 | A |
| Example 1-48 | UDL-48 | A |
| Example 1-49 | UDL-49 | A |
| Comp. Ex. 1-1 | Comp. Ex. UDL-1 | B |
| Comp. Ex. 1-2 | Comp. Ex. UDL-2 | A |
| Comp. Ex. 1-3 | Comp. Ex. UDL-3 | A |

As shown in Tables 6-1 to 6-2, it was found that in Examples 1-1 to 1-49 each using the composition for forming a metal-containing film of the present invention, good etching resistance to O₂ gas was demonstrated. On the other hand, in Comparative Example 1-1 using Comparative Example UDL-1 containing no metal source (B), degraded dry etching resistance was confirmed. Accordingly, the composition for forming a metal-containing film that contains the metal source (B) of the present invention can provide an excellent patterning process capable of transferring a resist upper layer film pattern to a substrate to be processed with high precision.

### Examples 2-1 to 2-49, Comparative Examples 2-1 to 2-3: Patterning Test (Sensitivity Evaluation)

On a silicon wafer with 100 nm of SiO₂ deposited thereon, a SOC film (ODL-306, carbon content: 61 atomic%) produced by Shin-Etsu Chemical Co., Ltd. was applied by spin coating and baked at 350°C for 60 seconds, thereby forming a carbon film having a film thickness of 45 nm as an organic resist underlayer film. Next, the above composition for forming a metal-containing film (UDL-1 to 49 and Comparative Example UDL-1 to 3) was applied on the organic resist underlayer film and heated at 220°C for 60 seconds using a hot plate, thereby forming a resist middle layer film having a film thickness of 10 nm.

Next, the resist material with the composition shown in Table 7 was spin-coated on the above resist middle layer film and pre-baked at 105°C for 60 seconds using a hot plate, thereby forming a resist film having a film thickness of 35 nm. This was exposed using an EUV scanner NXE3300 produced by ASML Holding N.V. (NA 0.33, σ 0.9/0.6, quadrupole illumination, L/S pattern at a pitch 44 nm on-wafer size), subjected to PEB on a hot plate at 100°C for 60 seconds, and developed in a 2.38% by mass of TMAH aqueous solution for 30 seconds, thereby obtaining a pattern having a line dimension of 22 nm.

The length of this line dimension was measured using a CD-SEM (CG5000) produced by Hitachi High-Tech Corporation, and pattern collapse was determined. The patterns formed with no collapse were then evaluated as follows.

The cross-sectional shape was observed using an electron microscope (S-4800) produced by Hitachi High-Tech Corporation. Furthermore, the minimum dimension at which the line would be resolved without collapsing was determined by increasing the exposure dose and narrowing the line dimension, and reported as collapse limit (nm). The smaller value is preferable since it indicates higher collapse resistance.

Furthermore, the exposure dose at which the line dimension of 22 nm could be obtained was evaluated for the sensitivity. It was determined that the smaller the exposure dose, the better the contribution thereof to sensitivity enhancement of the resist upper layer film. The results are shown in Tables 8-1 to 8-2.

### Polymer :

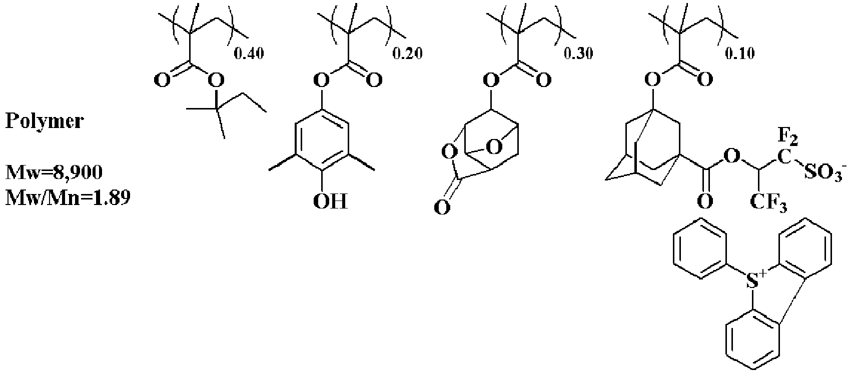

### Quencher .

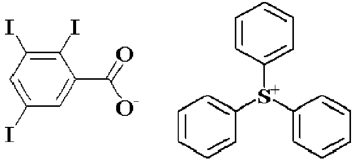

### Sensitizer .

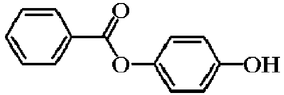

Surfactant: FC-4430 produced by 3M Company.

**[Table 7]**

| Component | Polymer | Quencher | Sensitizer | Surfactant | Organic Solvent |
|---|---|---|---|---|---|
| Composition (parts by mass) | (100) | (4.0) | (2.1) | (0.25) | PGMEA (400) |
| | | | | | CyHO (2000) |
| | | | | | P GME (100) |

| | | | | | |
|---|---|---|---|---|---|
| - Organic solvent: PGMEA (propylene glycol monomethyl ether acetate) CyHO (cyclohexanone) PGME (propylene glycol monomethyl ether) | | | | | |

Next, the resist middle layer film was processed by dry etching while using the resist upper layer film pattern as a mask, thereby forming a hard mask pattern. The organic underlayer film was etched by using the hard mask pattern thus obtained as a mask to form a pattern, and the SiO₂ film was processed by etching while using the resist underlayer film pattern thus obtained as a mask. Etching conditions are as described below.

The cross section of the pattern was observed using S-4800 (electron microscope produced by Hitachi Ltd.). The results are shown in Tables 8-1 to 8-2. The length of the line dimension after the processing was measured using a CD-SEM (CG5000) produced by Hitachi High-Tech Corporation, and a critical dimension for pattern collapse and LWR were determined.
(1) Conditions for processing the resist middle layer film
   Apparatus: dry etching system Telius SP produced by Tokyo Electron Limited
   Etching conditions (1):
      Chamber pressure: 80 mT
      RF power (upper portion): 500 W
      RF power (lower portion): 300 W
      CF₄ gas flow rate: 150 sccm
      CHF₃ gas flow rate: 50 sccm
      Time: 10 sec
(2) Conditions for processing the organic resist underlayer film
   Chamber pressure: 80 mT
   RF power (upper portion): 500 W
   RF power (lower portion): 300 W
   CO₂ gas flow rate: 320 sccm
   N₂ gas flow rate: 80 sccm
   Time: 40 sec
(3) Conditions for processing the oxide film (substrate to be processed)
   Chamber pressure: 10 mT
   RF power (upper portion): 100 W
   RF power (lower portion): 800 W
   CF₄ gas flow rate: 25 sccm
   CHF₃ gas flow rate: 15 sccm
   O₂ gas flow rate: 5 sccm
   Time: 60 sec

**[Table 8-1]**

| Example | Composition for forming metal-containing film | L/S patterning test | | | |
|---|---|---|---|---|---|
| | | Sensitivity mJ/cm2 | Cross section after development | Collapse limit (nm) | LWR after processing |
| Example 2-1 | UDL-1 | 22.3 | Vertical profile | 13.8 | 3.1 |
| Example 2-2 | UDL-2 | 22.3 | Vertical profile | 14.5 | 3.2 |
| Example 2-3 | UDL-3 | 22.2 | Vertical profile | 13.6 | 3.1 |
| Example 2-4 | UDL-4 | 22.4 | Vertical profile | 14.3 | 3.3 |
| Example 2-5 | UDL-5 | 22.3 | Vertical profile | 14.3 | 3.3 |
| Example 2-6 | UDL-6 | 22.3 | Vertical profile | 14.1 | 3.4 |
| Example 2-7 | UDL-7 | 22.3 | Vertical profile | 13.9 | 3.3 |
| Example 2-8 | UDL-8 | 22.5 | Vertical profile | 14.9 | 3.5 |
| Example 2-9 | UDL-9 | 22.6 | Vertical profile | 14.0 | 3.2 |
| Example 2-10 | UDL-10 | 22.5 | Vertical profile | 14.2 | 3.1 |
| Example 2-11 | UDL-11 | 22.4 | Vertical profile | 14.1 | 3.2 |
| Example 2-12 | UDL-12 | 22.4 | Vertical profile | 14.1 | 3.2 |
| Example 2-13 | UDL-13 | 22.3 | Vertical profile | 14.2 | 3.2 |
| Example 2-14 | UDL-14 | 22.4 | Vertical profile | 14.2 | 3.2 |
| Example 2-15 | UDL-15 | 22.3 | Vertical profile | 13.8 | 3.1 |
| Example 2-16 | UDL-16 | 22.4 | Vertical profile | 14.4 | 3.3 |
| Example 2-17 | UDL-17 | 22.2 | Vertical profile | 13.5 | 3.2 |
| Example 2-18 | UDL-18 | 22.4 | Vertical profile | 14.3 | 3.3 |
| Example 2-19 | UDL-19 | 22.5 | Vertical profile | 14.4 | 3.3 |
| Example 2-20 | UDL-20 | 22.4 | Vertical profile | 14 | 3.3 |
| Example 2-21 | UDL-21 | 22.3 | Vertical profile | 13.9 | 3.3 |
| Example 2-22 | UDL-22 | 22.6 | Vertical profile | 14.8 | 3.5 |
| Example 2-23 | UDL-23 | 24.4 | Vertical profile | 13.7 | 3.2 |
| Example 2-24 | UDL-24 | 24.2 | Vertical profile | 13.8 | 3.3 |
| Example 2-25 | UDL-25 | 24.3 | Vertical profile | 13.9 | 3.4 |
| Example 2-26 | UDL-26 | 24 | Vertical profile | 14.1 | 3.5 |

**[Table 8-2]**

| Example | Composition for forming metal-containing film | L/S patterning test | | | |
|---|---|---|---|---|---|
| | | Sensitivity mJ/cm2 | Cross section after development | Collapse limit (nm) | LWR after processing |
| Example 2-27 | UDL-27 | 24.1 | Vertical profile | 13.9 | 3.4 |
| Example 2-28 | UDL-28 | 24.2 | Vertical profile | 13.8 | 3.4 |
| Example 2-29 | UDL-29 | 24.1 | Vertical profile | 13.9 | 3.5 |
| Example 2-30 | UDL-30 | 24 | Vertical profile | 14 | 3.4 |
| Example 2-31 | UDL-31 | 24.7 | Vertical profile | 13.8 | 3.2 |
| Example 2-32 | UDL-32 | 24.8 | Vertical profile | 13.9 | 3.4 |
| Example 2-33 | UDL-33 | 23.3 | Vertical profile | 14 | 3.5 |
| Example 2-34 | UDL-34 | 22.8 | Vertical profile | 13.9 | 3.3 |
| Example 2-35 | UDL-35 | 21.7 | Vertical profile | 13.6 | 3.2 |
| Example 2-36 | UDL-36 | 22.3 | Vertical profile | 13.8 | 3.2 |
| Example 2-37 | UDL-37 | 21.9 | Vertical profile | 13.8 | 3.2 |
| Example 2-38 | UDL-38 | 23.7 | Vertical profile | 13.7 | 3.3 |
| Example 2-39 | UDL-39 | 23.2 | Vertical profile | 13.8 | 3.4 |
| Example 2-40 | UDL-40 | 21.7 | Vertical profile | 13.6 | 3.2 |
| Example 2-41 | UDL-41 | 21.5 | Vertical profile | 13.8 | 3.2 |
| Example 2-42 | UDL-42 | 22.5 | Vertical profile | 13.5 | 3.2 |
| Example 2-43 | UDL-43 | 24.4 | Vertical profile | 13.7 | 3.2 |
| Example 2-44 | UDL-44 | 24.2 | Vertical profile | 13.9 | 3.4 |
| Example 2-45 | UDL-45 | 24.2 | Vertical profile | 13.9 | 3.5 |
| Example 2-46 | UDL-46 | 24.7 | Vertical profile | 13.8 | 3.4 |
| Example 2-47 | UDL-47 | 21.8 | Vertical profile | 13.6 | 3.3 |
| Example 2-48 | UDL-48 | 23.2 | Vertical profile | 13.7 | 3.4 |
| Example 2-49 | UDL-49 | 23.7 | Vertical profile | 13.5 | 3.2 |
| Comp. Ex. 2-1 | Comp. Ex. UDL-1 | 26.5 | Vertical profile | 13.3 | 4.1 |
| Comp. Ex. 2-2 | Comp. Ex. UDL-2 | Pattern collapse | Pattern collapse | Pattern collapse | - |
| Comp. Ex. 2-3 | Comp. Ex. UDL-3 | 24.9 | Vertical profile | 14.2 | 4.7 |

As shown in Tables 8-1 to 8-2, in Examples 2-1 to 2-49 each using the composition for forming a metal-containing film of the present invention, formation of a pattern having a line width of 22 nm using EUV exposure yielded a pattern cross section of a vertical profile, and no pattern collapse was recognized. On the other hand, in Comparative Example 2-2 using Comparative Example UDL-2 containing no silicon-containing polymer, collapse of the resist pattern was observed.

Additionally, it was found that in Examples 2-1 to 2-7 and 2-35 each using the silicon-containing polymer that contained the polysiloxane containing an organic group having one or more carbon-oxygen single bonds or carbon-oxygen double bonds, a finer pattern could be formed as compared with Example 2-8 using the polysiloxane containing no organic group having one or more carbon-oxygen single bonds or carbon-oxygen double bonds. It is presumed that these compositions contained the silicon-containing polymer excellent in adhesiveness, and thus demonstrated excellent prevention effect on pattern collapse and good pattern formation effect even in the pattern having a line width of 22 nm.

It was confirmed that when the composition for forming a metal-containing film of the present invention was used for a resist middle layer film, the pattern could be formed with high sensitivity (Examples 2-1 to 2-49). This demonstrates that the above resist middle layer film can contribute to sensitivity enhancement while keeping LWR of the upper layer resist. In Examples 1-23 to 1-39, the compositions for forming a metal-containing film UDL-23 to 39 were evaluated, where various metal sources (B) were added while the silicon-containing polymer was fixed to the compound 9. In Examples 1-34 to 1-37 each using the composition for forming a metal-containing film containing Sn in the metal source (B), especially excellent sensitivity was exhibited.

Furthermore, in Comparative Example 2-1 using Comparative Example UDL-1 containing no metal source (B), and Comparative Example 2-3 using Comparative Example UDL-3 containing a metal nanoparticle as the metal source (B), degraded LWR was observed after the processing. It was found by an X-ray diffraction method that the resist middle layer film formed using Comparative Example UDL-3 showed crystallinity. It is presumed that this caused degraded line width roughness (LWR) of the pattern during etching of the substrate to be processed.

As described above, the present invention can overcome the trade-off relationship between sensitivity and LWR and form a resist underlayer film or middle layer film capable of contributing to sensitivity enhancement while keeping LWR of an upper layer resist. Accordingly, the present invention is highly useful in the field of EUV lithography.

The present description encompasses the following inventions.
[1]: A composition for forming a metal-containing film, comprising (A) a silicon-containing polymer containing polysiloxane, polycarbosilane, or polysilane, (B) a metal source, and (C) an organic solvent,
   wherein the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.
[2]: The composition for forming a metal-containing film according to [1], wherein the polysiloxane in the component (A) contains any one or more of a repeating unit represented by the following general formula (Sx-1), a repeating unit represented by the following general formula (Sx-2), and a partial structure represented by the following general formula (Sx-3), 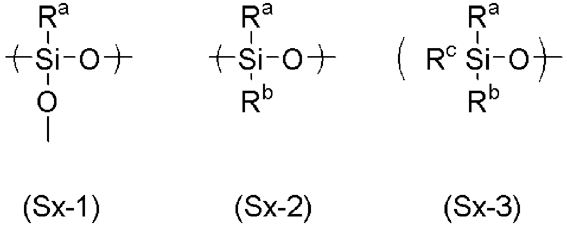 wherein R^{a}, R^{b}, and R^{c} are identical to or different from each other, and each represents a monovalent organic group having 1 to 30 carbon atoms.
[3]: The composition for forming a metal-containing film according to [2], wherein at least one of the R^{a} to R^{c} in the formulae (Sx-1) to (Sx-3) represents an organic group having one or more carbon-oxygen single bonds or carbon-oxygen double bonds.
[4]: The composition for forming a metal-containing film according to any one of [1] to [3], wherein the polycarbosilane in the component (A) contains a unit structure represented by the following general formula (Sy-1), 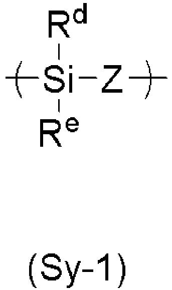 wherein R^{d} and R^{e} each independently represents a hydrogen atom, a hydroxy group, a halogen atom, or a monovalent organic group having 1 to 30 carbon atoms; and Z represents a substituted or unsubstituted divalent hydrocarbon group having 1 to 20 carbon atoms.
[5]: The composition for forming a metal-containing film according to any one of [1] to [4], wherein the polysilane in the component (A) contains a repeating unit represented by the following general formula (Sz-1),

   (R⁹R¹⁰R¹¹Si)ₐ₂(R¹²R¹³Si)ₐ₃(R¹⁴Si)ₐ₄(Si)ₐ₅ (Sz-1)

   wherein each of R⁹, R¹⁰, R¹¹, R¹², R¹³, and R¹⁴ represents a methyl group, a phenyl group, or a hydroxyl group; and "a2", "a3", "a4", and "a5" each represents a mole fraction, satisfying a2+a3+a4+a5=1, 0≤a2≤1, 0≤a3≤1, 0≤a4≤1, and 0≤a5≤1.
[6]: The composition for forming a metal-containing film according to any one of [1] to [5], wherein the metal source (B) is a salt of the metal with a monovalent to tetravalent carboxylic acid having 1 to 30 carbon atoms.
[7]: The composition for forming a metal-containing film according to any one of [1] to [6], wherein the metal source (B) has a structure represented by the following formula (B-1), 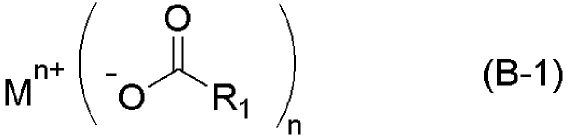 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.
[8]: The composition for forming a metal-containing film according to [7], wherein R₁ in the formula (B-1) represents a saturated or unsaturated hydrocarbon group having 1 to 10 carbon atoms.
[9]: The composition for forming a metal-containing film according to [7] or [8], wherein R₁ in the formula (B-1) represents a branched alkyl group having 3 to 10 carbon atoms.
[10]: The composition for forming a metal-containing film according to any one of [1] to [9], wherein the metal of the metal source (B) is Sn.
[11]: The composition for forming a metal-containing film according to any one of [1] to [10], further comprising one or more of (D) a crosslinking agent, (E) an acid generator, (F) a surfactant, and (G) a colorant.
[12] The composition for forming a metal-containing film according to any one of [1] to [11], wherein the organic solvent (C) is a mixture of one or more kinds of organic solvents having a boiling point of less than 180°C and one or more kinds of organic solvents having a boiling point of 180°C or higher ((C') a high-boiling-point solvent).
[13]: A patterning process for forming a pattern in a substrate to be processed, comprising steps of: (I-1) applying the composition for forming a metal-containing film according to any one of [1] to [12] on the substrate to be processed and thereafter performing heat treatment to form a metal-containing film; (I-2) forming a resist upper layer film on the metal-containing film using a photoresist material; (I-3) forming a pattern in the resist upper layer film by developing the resist upper layer film using a developer after pattern exposure; (I-4) transferring the pattern to the metal-containing film by dry etching while using the resist upper layer film having the formed pattern as a mask; and (I-5) processing the substrate to be processed while using the metal-containing film having the formed pattern as a mask to form the pattern in the substrate to be processed.
[14]: A patterning process for forming a pattern in a substrate to be processed, comprising steps of: (II-1) forming an organic resist underlayer film on the substrate to be processed; (II-2) applying the composition for forming a metal-containing film according to any one of [1] to [12] on the organic resist underlayer film and thereafter performing heat treatment to form a metal-containing film; (II-3) forming a resist upper layer film on the metal-containing film using a photoresist material; (II-4) forming a pattern in the resist upper layer film by developing the resist upper layer film using a developer after pattern exposure; (II-5) transferring the pattern to the metal-containing film by dry etching while using the resist upper layer film having the formed pattern as a mask; (II-6) transferring the pattern to the organic resist underlayer film by dry etching while using the metal-containing film having the transferred pattern as a mask; and (II-7) processing the substrate to be processed while using the organic resist underlayer film having the formed pattern as a mask to form the pattern in the substrate to be processed.
[15]: The patterning process according to [13], wherein the pattern exposure is performed using EUV light in the step (I-3) .
[16]: The patterning process according to [14], wherein the pattern exposure is performed using EUV light in the step (II-4).

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A composition for forming a metal-containing film, comprising (A) a silicon-containing polymer containing polysiloxane, polycarbosilane, or polysilane, (B) a metal source, and (C) an organic solvent,
wherein the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

2. The composition for forming a metal-containing film according to claim 1, wherein the polysiloxane in the component (A) contains any one or more of a repeating unit represented by the following general formula (Sx-1), a repeating unit represented by the following general formula (Sx-2), and a partial structure represented by the following general formula (Sx-3), 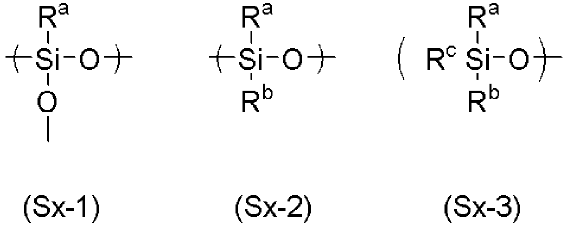 wherein R^{a}, R^{b}, and R^{c} are identical to or different from each other, and each represents a monovalent organic group having 1 to 30 carbon atoms.

3. The composition for forming a metal-containing film according to claim 2, wherein at least one of the R^{a} to R^{c} in the formulae (Sx-1) to (Sx-3) represents an organic group having one or more carbon-oxygen single bonds or

4. The composition for forming a metal-containing film according to claim 1, wherein the polycarbosilane in the component (A) contains a unit structure represented by the following general formula (Sy-1), 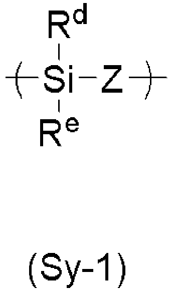 wherein R^{d} and R^{e} each independently represents a hydrogen atom, a hydroxy group, a halogen atom, or a monovalent organic group having 1 to 30 carbon atoms; and Z represents a substituted or unsubstituted divalent hydrocarbon group having 1 to 20 carbon atoms.

5. The composition for forming a metal-containing film according to claim 1, wherein the polysilane in the component (A) contains a repeating unit represented by the following general formula (Sz-1),
(R⁹R¹⁰R¹¹Si)ₐ₂(R¹²R¹³Si)ₐ₃(R¹⁴Si)ₐ₄(Si)ₐ₅ (Sz-1)
wherein each of R⁹, R¹⁰, R¹¹, R¹², R¹³, and R¹⁴ represents a methyl group, a phenyl group, or a hydroxyl group; and "a2", "a3", "a4", and "a5" each represents a mole fraction, satisfying a2+a3+a4+a5=1, 0≤a2≤1, 0≤a3≤1, 0≤a4≤1, and 0≤a5≤1.

6. The composition for forming a metal-containing film according to claim 1, wherein the metal source (B) is a salt of the metal with a monovalent to tetravalent carboxylic acid having 1 to 30 carbon atoms.

7. The composition for forming a metal-containing film according to claim 1, wherein the metal source (B) has a structure represented by the following formula (B-1), 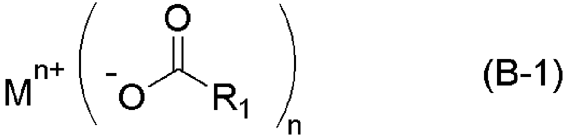 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.

8. The composition for forming a metal-containing film according to claim 7, wherein R₁ in the formula (B-1) represents a saturated or unsaturated hydrocarbon group having 1 to 10 carbon atoms.

9. The composition for forming a metal-containing film according to claim 7, wherein R₁ in the formula (B-1) represents a branched alkyl group having 3 to 10 carbon atoms.

10. The composition for forming a metal-containing film according to claim 1, wherein the metal of the metal source (B) is Sn.

11. The composition for forming a metal-containing film according to claim 1, further comprising one or more of (D) a crosslinking agent, (E) an acid generator, (F) a surfactant, and (G) a colorant.

12. The composition for forming a metal-containing film according to claim 1, wherein the organic solvent (C) is a mixture of one or more kinds of organic solvents having a boiling point of less than 180°C and one or more kinds of organic solvents having a boiling point of 180°C or higher ((C') a high-boiling-point solvent).

13. A patterning process for forming a pattern in a substrate to be processed, comprising steps of:
(I-1) applying the composition for forming a metal-containing film according to any one of claims 1 to 12 on the substrate to be processed and thereafter performing heat treatment to form a metal-containing film;
(I-2) forming a resist upper layer film on the metal-containing film using a photoresist material;
(I-3) forming a pattern in the resist upper layer film by developing the resist upper layer film using a developer after pattern exposure;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed, preferably,
wherein the pattern exposure is performed using EUV light in the step (I-3).

14. A patterning process for forming a pattern in a substrate to be processed, comprising steps of:
(II-1) forming an organic resist underlayer film on the substrate to be processed;
(II-2) applying the composition for forming a metal-containing film according to any one of claims 1 to 12 on the organic resist underlayer film and thereafter performing heat treatment to form a metal-containing film;
(II-3) forming a resist upper layer film on the metal-containing film using a photoresist material;
(II-4) forming a pattern in the resist upper layer film by developing the resist upper layer film using a developer after pattern exposure;
(II-5) transferring the pattern to the metal-containing film by dry etching while using the resist upper layer film having the formed pattern as a mask;
(II-6) transferring the pattern to the organic resist underlayer film by dry etching while using the metal-containing film having the transferred pattern as a mask; and
(II-7) processing the substrate to be processed while using the organic resist underlayer film having the formed pattern as a mask to form the pattern in the substrate to be processed, preferably,
wherein the pattern exposure is performed using EUV light in the step (II-4).
